(19) **Europäisches Patentamt / European Patent Office / Office européen des brevets**

(11) **EP 4 693 888 A1**

(12) **EUROPEAN PATENT APPLICATION**
published in accordance with Art. 153(4) EPC

(43) Date of publication:
**11.02.2026 Bulletin 2026/07**

(21) Application number: **24780896.7**

(22) Date of filing: **29.03.2024**

(51) International Patent Classification (IPC):
**H02P 29/024** (2016.01)

(52) Cooperative Patent Classification (CPC):
**H02P 27/08; H02P 29/024**

(86) International application number:
**PCT/JP2024/013270**

(87) International publication number:
**WO 2024/204802 (03.10.2024 Gazette 2024/40)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **31.03.2023 JP 2023059353**

(71) Applicant: **Daikin Industries, Ltd.**
**Osaka-shi, Osaka 530-0001 (JP)**

(72) Inventors:
• **OKAMOTO, Hideyuki**
  **Osaka-shi, Osaka 530-0001 (JP)**
• **ARAKI, Takeshi**
  **Osaka-shi, Osaka 530-0001 (JP)**
• **OGAWA, Takuro**
  **Osaka-shi, Osaka 530-0001 (JP)**

(74) Representative: **Hoffmann Eitle**
**Patent- und Rechtsanwälte PartmbB**
**Arabellastraße 30**
**81925 München (DE)**

(54) **STATE INFERENCE DEVICE, DRIVE SYSTEM, REFRIGERATION SYSTEM, FAN SYSTEM, STATE INFERENCE METHOD, AND STATE INFERENCE PROGRAM**

(57)     In an estimation process, a control unit (31) estimates a state of a device (70), based on a specific frequency component (C1) of a physical quantity obtained from the device (70). In a restriction process, the control unit (31) restricts the estimation process or the operation of the motor (50) when a noise frequency component (Cn) included in the physical quantity and the specific frequency component (C1) satisfy a predetermined relationship. When a carrier frequency is represented by $f_c$, a frequency for sampling the physical quantity is represented by $f_s$, and an electrical angular frequency is represented by $f_a$, a frequency of a noise frequency component (Cn) is given by any one of Expressions 1 to 3 when the physical quantity is a DC signal, and is given by any one of Expressions 4 to 6 when the physical quantity is an AC signal:

[Math. 1]

$$|f_c \pm 6Nf_0| \cdots (1)$$
$$|Mf_s - 6Nf_0| \cdots (2)$$
$$|Mf_s - |f_c \pm 6Nf_0|| \cdots (3)$$
$$|f_0 \pm |f_c \pm 6Nf_0|| \cdots (4)$$
$$|f_0 \pm |Mf_s - 6Nf_0|| \cdots (5)$$
$$|f_0 \pm |Mf_s - |f_c \pm 6Nf_0||| \cdots (6)$$

where M and N are natural numbers.

# FIG.8

START

S101

NOISE FREQUENCY COMPONENT (Cn) AND SPECIFIC FREQUENCY COMPONENT (C1) SATISFYING PREDETERMINED RELATIONSHIP? — NO

YES

S102

RESTRICT ESTIMATION PROCESS OR OPERATION OF MOTOR

S103

RESTRICTION RELEASE CONDITION SATISFIED? — NO

YES

S104

RELEASE RESTRICTION

RETURN

RESTRICTION PROCESS ⟹ ESTIMATION PROCESS

CALCULATION PROCESS

$C_1$

ESTIMATION PROCESS

MOTOR OPERATION

ESTIMATION RESULT

2

EP 4 693 888 A1

**Description**

Technical Field

The present disclosure relates to a state estimation technique.

Background Art

PTL 1 discloses an abnormality diagnosis device for diagnosing an abnormality of an electric motor driven by pulse width modulation control of a power conversion device. The abnormality diagnosis device includes a detection unit, an analysis unit, a determination unit, and a frequency setting unit. The detection unit detects a current flowing through the electric motor. The analysis unit performs frequency analysis on the current detected by the detection unit and outputs an analysis result. The determination unit determines an abnormality of the electric motor, based on a spectrum peak of at least one sideband wave component of a modulation wave obtained from the analysis result. The frequency setting unit sets a noise frequency in the current in advance.

The frequency setting unit calculates a greatest common divisor of two or more frequencies including a modulation wave frequency among three frequencies used for the pulse width modulation control, namely, the modulation wave frequency, a carrier wave frequency, and a sampling frequency for sampling the modulation wave, and sets the greatest common divisor and an integer multiple thereof as noise frequencies. The determination unit estimates the presence or absence of noise interference in the spectrum peak of the sideband wave component, based on the frequency of the sideband wave component and the set noise frequencies, and determines the abnormality of the electric motor.

Citation List

Patent Literature

PTL 1: Japanese Patent No. 6824494

Summary of Invention

Technical Problem

A state estimation device (a device for estimating the state of a device) such as the abnormality diagnosis device in PTL 1 can detect only noise frequency components having frequencies that are the greatest common divisor described above (a greatest common divisor of at least 2) and integer multiples thereof, and thus cannot consider the influence of noise frequency components of frequencies other than the frequencies that are the greatest common divisor and integer multiples thereof. It is therefore difficult to appropriately suppress erroneous estimation of the state of the device.

Solution to Problem

A first aspect of the present disclosure relates to a state estimation device for estimating a state of a device (70) in which a motor (50) driven by an inverter (23) is mounted. The state estimation device includes a control unit (31). The control unit (31) is configured to perform an estimation process for estimating the state of the device (70), based on a magnitude of a specific frequency component (C1) of a physical quantity obtained from the device (70), and a restriction process for restricting the estimation process or an operation of the motor (50) when a noise frequency component (Cn) included in the physical quantity and the specific frequency component (C1) satisfy a predetermined relationship. The restriction process is a first restriction process for restricting the estimation process so that a predetermined estimation result is output, or a second restriction process for restricting the operation of the motor (50) so that no erroneous estimation is performed in the estimation process. When a carrier frequency of the inverter (23) is represented by $f_c$, a sampling frequency that is a reciprocal of a cycle for sampling the physical quantity is represented by $f_s$, and an electrical angular frequency of the motor (50) is represented by $f_0$, a frequency of the noise frequency component (Cn) is a frequency given by any one of Expression 1, Expression 2, and Expression 3 below when the physical quantity is a DC signal, and a frequency given by any one of Expression 4, Expression 5, and Expression 6 below when the physical quantity is an AC signal, under a condition in which a greatest common divisor, which is at least 2, of two or more frequencies including the electrical angular frequency among the electrical angular frequency, the carrier frequency, and a frequency for sampling a modulation wave used for controlling the inverter (23) does not exist:

3

[Math. 1]

$$|f_c \pm 6Nf_0| \cdots (1)$$
$$|Mf_s - 6Nf_0| \cdots (2)$$
$$|Mf_s - |f_c \pm 6Nf_0|| \cdots (3)$$
$$|f_0 \pm |f_c \pm 6Nf_0|| \cdots (4)$$
$$|f_0 \pm |Mf_s - 6Nf_0|| \cdots (5)$$
$$|f_0 \pm |Mf_s - |f_c \pm 6Nf_0||| \cdots (6)$$

where M and N are natural numbers.

In the first aspect, the noise frequency component (Cn) having a frequency given by any one of Expressions 1 to 6 is a frequency component that may affect the specific frequency component (C1). In the restriction process, accordingly, by restricting the estimation process or the operation of the motor (50) based on the relationship between the noise frequency component (Cn) and the specific frequency component (C1), it is possible to suppress erroneous estimation of the state of the device (70).

In the first aspect, it is possible to consider the influence of noise frequency components having frequencies other than "frequencies that are the greatest common divisor disclosed in PTL 1 (a greatest common divisor of at least 2) and integer multiples thereof". Thus, it is possible to appropriately suppress erroneous estimation of the state of the device (70).

A second aspect of the present disclosure provides the state estimation device according to the first aspect, in which the predetermined relationship is a relationship in which a frequency difference between the noise frequency component (Cn) and the specific frequency component (C1) is less than or equal to a predetermined frequency difference threshold value.

In the second aspect, by restricting the estimation process or the operation of the motor (50) based on the frequency difference between the noise frequency component (Cn) and the specific frequency component (C1), it is possible to suppress erroneous estimation of the state of the device (70).

A third aspect of the present disclosure provides the state estimation device according to the second aspect, in which the frequency difference threshold value is 3 Hz.

In the third aspect, it is possible to restrict the estimation process or the operation of the motor (50) when the "range of variation of the specific frequency component (C1) affected by the noise frequency component (Cn)" is greater than 10% of the "amplitude of the specific frequency component (C1) not affected by the noise frequency component (Cn)". Thus, it is possible to appropriately suppress erroneous estimation of the state of the device (70).

A fourth aspect of the present disclosure provides the state estimation device according to any one of the first to third aspects, in which the first restriction process is a process for prohibiting execution of the estimation process.

In the fourth aspect, by prohibiting the execution of the estimation process, it is possible to prevent an erroneous estimation result from being obtained. Thus, it is possible to suppress erroneous estimation of the state of the device (70).

A fifth aspect of the present disclosure provides the state estimation device according to any one of the first to third aspects, in which the control unit (31) is configured to estimate the state of the device (70) in the estimation process, based on a result of comparison between a variable calculated based on an amplitude of the specific frequency component (C1) and a predetermined threshold value, and the first restriction process is a process for correcting at least one of the threshold value and the amplitude of the specific frequency component (C1).

In the fifth aspect, by correcting at least one of the threshold value used in the estimation process and the amplitude of the specific frequency component (C1), it is possible to prevent an erroneous estimation result from being obtained. Thus, it is possible to suppress erroneous estimation of the state of the device (70).

A sixth aspect of the present disclosure provides the state estimation device according to any one of the first to third aspects, in which the second restriction process is a process for changing an operation condition of the motor (50) so that no erroneous estimation is performed in the estimation process.

In the sixth aspect, by changing the operation condition of the motor (50), it is possible to prevent the noise frequency component (Cn) and the specific frequency component (C1) from satisfying the predetermined relationship. Thus, it is possible to suppress the variation in the magnitude of the specific frequency component (C1) due to the influence of the noise frequency component (Cn), thereby enabling suppression of the erroneous estimation of the state of the device (70).

A seventh aspect of the present disclosure provides the state estimation device according to the sixth aspect, in which the process for changing the operation condition of the motor (50) is a process for changing at least one of the carrier frequency, the sampling frequency, and a mechanical angular frequency of the motor (50).

In the seventh aspect, by changing at least one of the carrier frequency, the sampling frequency, and the mechanical angular frequency of the motor (50), it is possible to prevent the noise frequency component (Cn) and the specific frequency component (C1) from satisfying the predetermined relationship. Thus, it is possible to suppress the variation in the magnitude of the specific frequency component (C1) due to the influence of the noise frequency component (Cn), thereby enabling suppression of the erroneous estimation of the state of the device (70).

An eighth aspect of the present disclosure provides the state estimation device according to any one of the first to third aspects, in which the second restriction process is a process for prohibiting the operation of the motor (50) under an operation condition in which the noise frequency component (Cn) and the specific frequency component (C1) satisfy the predetermined relationship.

In the eighth aspect, by prohibiting the operation of the motor (50) under the operation condition in which the noise frequency component (Cn) and the specific frequency component (C1) satisfy the predetermined relationship, it is possible to prevent an erroneous estimation result from being obtained. Thus, it is possible to suppress erroneous estimation of the state of the device (70).

A ninth aspect of the present disclosure provides the state estimation device according to any one of the first to eighth aspects, in which a frequency of the specific frequency component (C1) is a frequency that is at least one of 1 time, 1/3 times, and 2/3 times a mechanical angular frequency of the motor (50) when the physical quantity is a DC signal, and at least one of a frequency obtained by adding a predetermined frequency to the electrical angular frequency, a frequency obtained by subtracting the predetermined frequency from the electrical angular frequency, and a frequency that is 3 times the electrical angular frequency when the physical quantity is an AC signal, the predetermined frequency being any one of 1 time, 1/3 times, and 2/3 times the mechanical angular frequency.

In the ninth aspect, it is possible to estimate various states (particularly, an abnormality) of the device (70).

A tenth aspect of the present disclosure provides the state estimation device according to any one of the first to ninth aspects, in which in the restriction process, when a predetermined restriction release condition is satisfied after restriction of the estimation process or restriction of the operation of the motor (50) is started, the control unit (31) is configured to release the restriction after a predetermined standby release condition is satisfied.

In the tenth aspect, it is possible to release the restriction (the restriction of the estimation process or the restriction of the motor (50)) after stabilizing the specific frequency component (C1) used in the estimation process, compared to a case where the restriction (the restriction of the estimation process or the restriction of the motor (50)) is released after the restriction release condition is satisfied without waiting for the standby release condition to be satisfied. Thus, it is possible to suppress erroneous estimation of the state of the device (70) after the restriction is released.

An eleventh aspect of the present disclosure provides the state estimation device according to any one of the first to tenth aspects, in which the control unit (31) is configured to estimate presence or absence of an abnormality of the device (70) in the estimation process, and the predetermined estimation result is an estimation result that is not an estimation result indicating that the device (70) is abnormal.

In the eleventh aspect, it is possible to prevent the erroneous estimation that the device (70) is abnormal.

A twelfth aspect of the present disclosure is a state estimation device for estimating a state of a device in which a motor (50) is mounted. The state estimation device includes a control unit (31). The control unit (31) is configured to perform an estimation process for estimating the state of the device (70), based on a magnitude of a specific frequency component (C1) of a physical quantity obtained from the device (70), and a restriction process for restricting the estimation process or an operation of the motor (50), based on a magnitude of a periodic component included in a variable calculated based on the magnitude of the specific frequency component (C1). The restriction process is a first restriction process for restricting the estimation process so that a predetermined estimation result is output, or a second restriction process for restricting the operation of the motor (50) so that no erroneous estimation is performed in the estimation process.

In the twelfth aspect, when the noise component affects the specific frequency component (C1), the magnitude (amplitude) of the specific frequency component (C1) varies. Therefore, by restricting the estimation process or an operation of the motor (50), based on the "magnitude of a periodic component included in a variable calculated based on the magnitude of the specific frequency component (C1)", it is possible to suppress erroneous estimation of the state of the device (70).

In the twelfth aspect, it is possible to consider the influence of noise frequency components having frequencies other than "frequencies that are the greatest common divisor disclosed in PTL 1 (a greatest common divisor of at least 2) and integer multiples thereof". Thus, it is possible to appropriately suppress erroneous estimation of the state of the device (70).

A thirteenth aspect of the present disclosure relates to a drive system including a motor drive device (20) configured to drive a motor (50) mounted in a device (70), and a state estimation device configured to estimate an abnormality of the device (70). The state estimation device is the state estimation device according to any one of the first to twelfth aspects.

A fourteenth aspect of the present disclosure relates to a refrigeration system including a refrigerant circuit (RR1) including a compressor (CC) including a motor (50), and a state estimation device. The state estimation device is the state estimation device according to any one of the first to twelfth aspects, and is configured to estimate a state of the refrigeration system.

A fifteenth aspect of the present disclosure relates to a fan system including a fan (FF1) including a motor (50), and a state estimation device. The state estimation device is the state estimation device according to any one of the first to twelfth aspects, and is configured to estimate a state of the fan system.

A sixteenth aspect of the present disclosure relates to a state estimation method for estimating a state of a device (70) in which a motor (50) driven by an inverter (23) is mounted. The state estimation method includes an estimation step of estimating the state of the device (70), based on a magnitude of a specific frequency component (C1) of a physical quantity obtained from the device (70), and a restriction step of restricting the estimation step or an operation of the motor (50) when a noise frequency component (Cn) included in the physical quantity and the specific frequency component (C1) satisfy a predetermined relationship. The restriction step is a first restriction step of restricting the estimation step so that a predetermined estimation result is output, or a second restriction step of restricting the operation of the motor (50) so that no erroneous estimation is performed in the estimation step. When a carrier frequency of the inverter (23) is represented by $f_c$, a sampling frequency that is a reciprocal of a cycle for sampling the physical quantity is represented by $f_s$, and an electrical angular frequency of the motor (50) is represented by $f_0$, a frequency of the noise frequency component (Cn) is a frequency given by any one of Expression 1, Expression 2, and Expression 3 below when the physical quantity is a DC signal, and a frequency given by any one of Expression 4, Expression 5, and Expression 6 below when the physical quantity is an AC signal, under a condition in which a greatest common divisor, which is at least 2, of two or more frequencies including the electrical angular frequency among the electrical angular frequency, the carrier frequency, and a frequency for sampling a modulation wave used for controlling the inverter (23) does not exist:

[Math. 2]

$$|f_c \pm 6Nf_0| \cdots (1)$$
$$|Mf_s - 6Nf_0| \cdots (2)$$
$$|Mf_s - |f_c \pm 6Nf_0|| \cdots (3)$$
$$|f_0 \pm |f_c \pm 6Nf_0|| \cdots (4)$$
$$|f_0 \pm |Mf_s - 6Nf_0|| \cdots (5)$$
$$|f_0 \pm |Mf_s - |f_c \pm 6Nf_0||| \cdots (6)$$

where M and N are natural numbers.

In the sixteenth aspect, the noise frequency component (Cn) having a frequency given by any one of Expressions 1 to 6 is a frequency component that may affect the specific frequency component (C1). In the restriction step, accordingly, by restricting the estimation process or the operation of the motor (50) based on the relationship between the noise frequency component (Cn) and the specific frequency component (C1), it is possible to suppress erroneous estimation of the state of the device (70).

In the sixteenth aspect, it is possible to consider the influence of noise frequency components having frequencies other than "frequencies that are the greatest common divisor disclosed in PTL 1 (a greatest common divisor of at least 2) and integer multiples thereof". Thus, it is possible to appropriately suppress erroneous estimation of the state of the device (70).

A seventeenth aspect of the present disclosure relates to a state estimation method for estimating a state of a device in which a motor (50) is mounted. The state estimation method includes an estimation step of estimating the state of the device (70), based on a magnitude of a specific frequency component (C1) of a physical quantity obtained from the device (70), and a restriction step of restricting the estimation step or an operation of the motor (50), based on a magnitude of a periodic component included in a variable calculated based on the magnitude of the specific frequency component (C1). The restriction step is a first restriction step of restricting the estimation step so that a predetermined estimation result is output, or a second restriction step of restricting the operation of the motor (50) so that no erroneous estimation is performed in the estimation step.

In the seventeenth aspect, when the noise component affects the specific frequency component (C1), the magnitude (amplitude) of the specific frequency component (C1) varies. Therefore, by restricting the estimation step or an operation of the motor (50), based on the "magnitude of a periodic component included in a variable calculated based on the magnitude of the specific frequency component (C1)", it is possible to suppress erroneous estimation of the state of the device (70).

In the seventeenth aspect, it is possible to consider the influence of noise frequency components having frequencies other than "frequencies that are the greatest common divisor disclosed in PTL 1 (a greatest common divisor of at least 2) and integer multiples thereof". Thus, it is possible to appropriately suppress erroneous estimation of the state of the device (70).

An eighteenth aspect of the present disclosure relates to a state estimation program for causing a computer to execute the state estimation method according to the sixteenth or seventeenth aspect.

Brief Description of Drawings

[Fig. 1] Fig. 1 is a circuit diagram illustrating a configuration of a drive system according to Embodiment 1.

[Fig. 2] Fig. 2 is a schematic diagram illustrating the flow of a control process.

[Fig. 3] Fig. 3 is a graph illustrating a specific frequency component and a noise frequency component.

[Fig. 4] Fig. 4 is a graph illustrating the waveform of the specific frequency component that varies due to the noise frequency component.

[Fig. 5] Fig. 5 is a graph illustrating the waveform of the specific frequency component in a case where the frequency difference between the noise frequency component and the specific frequency component is relatively large.

[Fig. 6] Fig. 6 is a graph illustrating the waveform of the specific frequency component in a case where the frequency difference between the noise frequency component and the specific frequency component is relatively small.

[Fig. 7] Fig. 7 is a graph illustrating the relationship between the frequency difference between the noise frequency component and the specific frequency component and the range of variation of the specific frequency component.

[Fig. 8] Fig. 8 is a flowchart illustrating the flow of processes by a control unit according to Embodiment 1.

[Fig. 9] Fig. 9 is a graph illustrating specific examples of the specific frequency component and the noise frequency component.

[Fig. 10] Fig. 10 is a graph illustrating a specific frequency range that is based on the frequency of the specific frequency component.

[Fig. 11] Fig. 11 is a flowchart illustrating a first estimation process.

[Fig. 12] Fig. 12 is a flowchart illustrating a second estimation process.

[Fig. 13] Fig. 13 is a timing chart illustrating the second estimation process.

[Fig. 14] Fig. 14 is a flowchart illustrating a third estimation process.

[Fig. 15] Fig. 15 is a timing chart illustrating the third estimation process.

[Fig. 16] Fig. 16 is a flowchart illustrating a fourth estimation process.

[Fig. 17] Fig. 17 is a timing chart illustrating the fourth estimation process.

[Fig. 18] Fig. 18 is a flowchart illustrating a restriction process according to Modification 1 of Embodiment 1.

[Fig. 19] Fig. 19 is a flowchart illustrating the flow of processes by a control unit according to Embodiment 2.

[Fig. 20] Fig. 20 is a graph for explaining an average value of amounts of change in the specific frequency component within a predetermined time.

[Fig. 21] Fig. 21 is a graph illustrating a periodic component extracted from the specific frequency component.

[Fig. 22] Fig. 22 is a graph for explaining a standard deviation of the specific frequency component within a predetermined time.

[Fig. 23] Fig. 23 is a graph for explaining the kurtosis of the distribution of the specific frequency component within a predetermined time.

[Fig. 24] Fig. 24 is a graph for explaining a cumulative value of absolute values of differences between the specific frequency component and an average value within a predetermined time.

[Fig. 25] Fig. 25 is a graph for explaining the magnitude of energy of a spectrum of the periodic component of the specific frequency component.

[Fig. 26] Fig. 26 is a graph for explaining a difference between a maximum value and a minimum value of the specific frequency component within a predetermined time.

[Fig. 27] Fig. 27 is a schematic diagram illustrating a configuration of a refrigeration system.

[Fig. 28] Fig. 28 is a schematic diagram illustrating a configuration of a fan system. Description of Embodiments

Hereinafter, embodiments will be described in detail with reference to the drawings. In the drawings, the same or corresponding parts are denoted by the same reference numerals, and the description thereof will not be repeated.

(Embodiment 1)

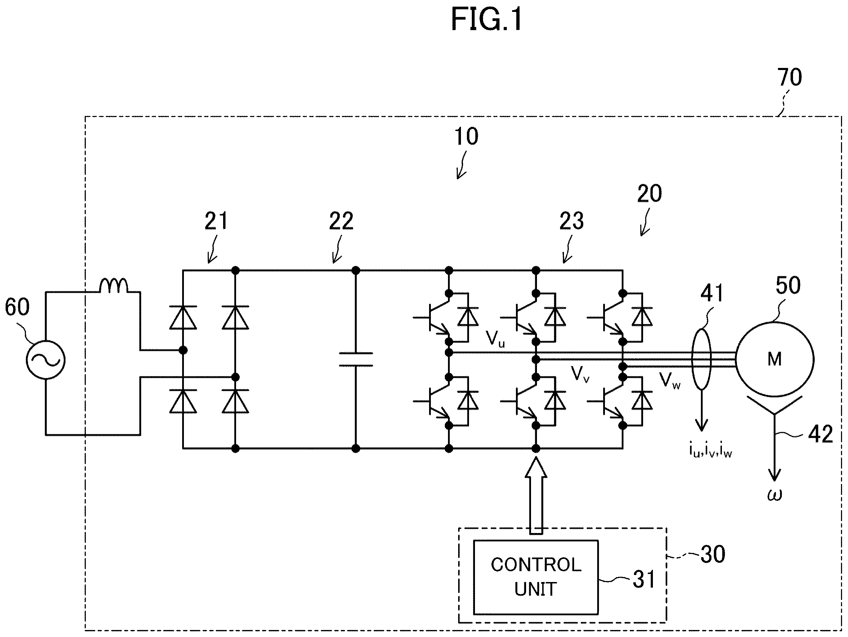

Fig. 1 illustrates a configuration of a drive system (10) according to Embodiment 1. The drive system (10) drives a motor (50) using electric power supplied from a power source (60). The motor (50) is mounted in a device (70). For example, the motor (50) is an IPM motor (Interior Permanent Magnet Motor). In this example, the power source (60) is an AC power source, and the motor (50) is a three-phase AC motor. The drive system (10) is mounted in the device (70). For example, the device (70) is an outdoor unit of an air conditioner. The drive system (10) includes a motor drive device (20) and a control device (30).

[Motor Drive Device]

The motor drive device (20) drives the motor (50). Specifically, the motor drive device (20) converts the electric power supplied from the power source (60) into output AC power (three-phase AC power in this example) having a predetermined frequency and voltage, and supplies the output AC power to the motor (50). In this example, the motor drive device (20) includes a converter (21), a DC unit (22), and an inverter (23).

The converter (21) rectifies the electric power supplied from the power source (60). In this example, the converter (21) performs full-wave rectification on AC power supplied from the power source (60). For example, the converter (21) is constituted by a diode bridge circuit in which a plurality of rectifier diodes are connected in a bridge shape.

The DC unit (22) generates DC power corresponding to power source power supplied from the power source (60). In this example, the DC unit (22) includes a capacitor and smooths an output of the converter (21).

The inverter (23) includes a plurality of switching elements, and converts an output of the DC unit (22) into output AC power (three-phase AC power) having a predetermined frequency and voltage by a switching operation of the plurality of switching elements.

In this example, the inverter (23) includes six bridge-connected switching elements and six freewheeling diodes respectively connected in anti-parallel to the six switching elements. More specifically, the inverter (23) includes three switching legs each of which includes two switching elements connected in series. Midpoints of the three switching legs (specifically, connection points between the switching elements on the upper arm side and the switching elements on the lower arm side) are respectively connected to three windings (U-phase, V-phase, and W-phase windings) of the motor (50).

[Various Sensors]

The motor drive device (20) is provided with various sensors such as a phase current detection unit (41) and an electrical angular frequency detection unit (42). Various types of information detected by the various sensors are transmitted to the control device (30). Specifically, detection signals of the various sensors are transmitted to a control unit (31) described below.

The phase current detection unit (41) detects three phase currents (a U-phase current (iu), a V-phase current (iv), and a W-phase current (iw)) respectively flowing through the three windings (not illustrated) of the motor (50). For example, the phase current detection unit (41) may detect all of the three phase currents (iu, iv, iw) or may detect two of the three phase currents (iu, iv, iw) and derive the remaining one phase current based on the detected two phase currents. The phase current detection unit (41) may derive the three phase currents (iu, iv, iw) from a DC current detected by a shunt resistance (not illustrated) provided in the DC unit (22) and a switching pattern.

The electrical angular frequency detection unit (42) detects an electrical angular frequency ($\omega$) of the motor (50). The electrical angular frequency detection unit (42) is not an essential component, and the electrical angular frequency ($\omega$) of the motor (50) may be calculated by another method and estimated in a sensorless manner.

[Control Device (State Estimation Device)]

The control device (30) estimates the state of the device (70). The control device (30) is an example of a state estimation device that estimates the state of the device (70) in which the motor (50) is mounted. The process in the control device (30) (the process related to the estimation of the state of the device (70)) is an example of a state estimation method for estimating the state of the device (70) in which the motor (50) is mounted.

In this example, the control device (30) estimates the presence or absence of an abnormality of the device (70) and deals with the abnormality of the device (70). The control device (30) controls the motor (50). Specifically, the control device (30) controls the motor (50) by controlling the motor drive device (20).

[Control Unit]

The control device (30) includes the control unit (31). The control unit (31) performs various processes. Specifically, the control unit (31) acquires information and data from each unit of the device (70), and performs the various processes based on the information and the data. The processes by the control unit (31) will be described in detail below.

For example, the control unit (31) includes a processor and a memory (storage medium) electrically connected to the processor and configured to store a program for operating the processor. The processor executes the program to implement various functions of the control unit (31). The control unit (31) is an example of a computer, and the program described above is an example of a state estimation program.

[Processes by Control Unit]

In this example, the control unit (31) performs a control process, a calculation process, an estimation process, and a countermeasure process. These various processes are examples of various steps. For example, the estimation process is an example of an estimation step.

[Control Process]

In the control process, the control unit (31) controls the motor drive device (20) to control the motor (50). Specifically, the control unit (31) receives a target command value such as a command value of the electrical angular frequency ($\omega$) of the motor (50), detection signals of the various sensors provided in the motor drive device (20), and the like. Then, the control unit (31) controls the switching operation of the inverter (23) based on the target command value, the detection signals of the various sensors, and the like to control the AC power to be supplied from the inverter (23) to the motor (50).

In this example, the control unit (31) receives a carrier wave signal indicating a carrier wave and a sampling clock. The carrier wave is a wave whose amplitude varies at a predetermined frequency (carrier frequency). The sampling clock is a signal indicating the timing of sampling.

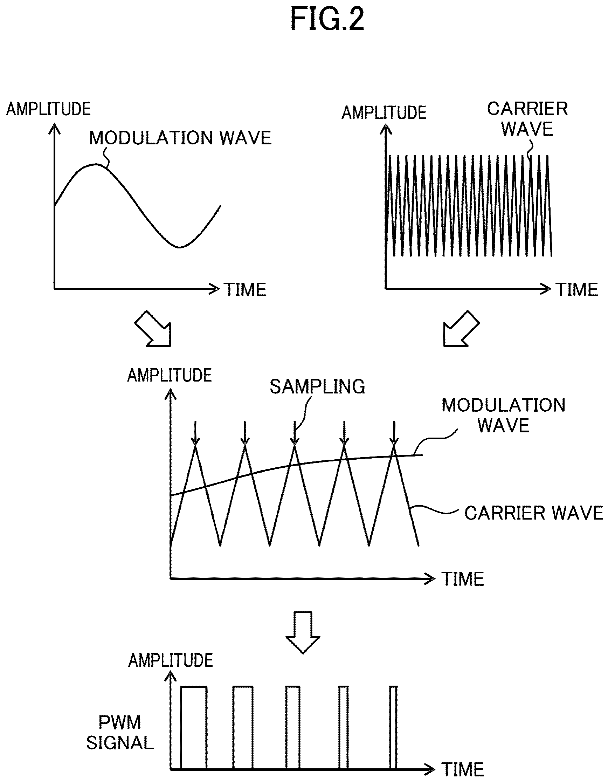

As illustrated in Fig. 2, the control unit (31) generates a modulation wave signal indicating a modulation wave. The modulation wave is a wave corresponding to the waveform of an output AC voltage having a predetermined frequency and voltage. The control unit (31) samples an instantaneous value of the modulation wave signal in synchronization with the sampling clock, and compares the instantaneous value of the modulation wave signal obtained by the sampling with the carrier wave signal.

Then, the control unit (31) generates a PWM signal for controlling a switching operation of the inverter (23), based on the comparison result. Specifically, when the instantaneous value of the sampled modulation wave signal is higher than the signal level (amplitude value) of the carrier wave signal, the signal level of the PWM signal becomes a high level, and when the instantaneous value of the sampled modulation wave signal is lower than the signal level of the carrier wave signal, the signal level of the PWM signal becomes a low level (for example, zero).

The PWM signal generated by the control unit (31) is supplied to the plurality of switching elements included in the inverter (23). The plurality of switching elements included in the inverter (23) are turned on and off in accordance with the PWM signal. Accordingly, output AC power having a predetermined frequency and voltage is generated.

The frequency of the carrier wave signal corresponds to the "carrier frequency of the inverter (23)". The reciprocal of the cycle for sampling the instantaneous value of the modulation wave signal corresponds to the "frequency for sampling a modulation wave used for controlling the inverter (23)".

[Calculation Process]

In the calculation process, the control unit (31) calculates a specific frequency component (C1) from a physical quantity obtained from the device (70). Specifically, the control unit (31) samples an instantaneous value of the physical quantity in a predetermined sampling cycle, and calculates the specific frequency component (C1), based on the sampled instantaneous value of the physical quantity. The sampling cycle is a "cycle for sampling a physical quantity", and the reciprocal thereof is a "sampling frequency".

In this example, the control unit (31) derives the specific frequency component (C1) of a signal based on the current or voltage of the motor (50). The signal based on the current or voltage of the motor (50) is an example of a physical quantity obtained from the device (70). Specific examples of the signal and the specific frequency component (C1) will be described in detail below.

[Estimation Process]

In the estimation process, the control unit (31) estimates the state of the device (70), based on the specific frequency component (C1) calculated by the calculation process (the specific frequency component (C1) of the physical quantity obtained from the device (70)). Then, the control unit (31) outputs the estimation result. In this example, the control unit (31) estimates the presence or absence of an abnormality of the device (70) in the estimation process. In the estimation process, the control unit (31) estimates the state of the device (70), based on the specific frequency component (C1) of the signal based on the current or voltage of the motor (50). Specific examples of the estimation process will be described in detail below.

[Restriction Process]

In the restriction process, the control unit (31) restricts the estimation process or the operation of the motor (50) when a noise frequency component (Cn) included in the physical quantity and the specific frequency component (C1) satisfy a predetermined relationship. The restriction process is a first restriction process for restricting the estimation process so that a predetermined estimation result is output, or a second restriction process for restricting the operation of the motor (50) so that no erroneous estimation is performed in the estimation process. The first restriction process and the second restriction process will be described in detail below.

In this example (example of estimating the presence or absence of an abnormality of the device (70) in the estimation process), the predetermined estimation result is an estimation result that is not an estimation result indicating that the device (70) is abnormal. Examples of the predetermined estimation result include an estimation result indicating that the device (70) is normal, an estimation result indicating that the state of the device (70) is unknown, an estimation result indicating that the estimation process is prohibited (stopped), and an estimation result output before (e.g., immediately before) the estimation process is restricted.

[Noise Frequency Component]

The noise frequency component (Cn) will now be described. In the following description, the carrier frequency of the inverter (23) is represented by "$f_c$", the sampling frequency, which is the reciprocal of the cycle for sampling the physical quantity, is represented by "$f_s$", and the electrical angular frequency of the motor (50) is represented by "$f_0$".

When the physical quantity is a DC signal, the noise frequency component (Cn) has a frequency given by any one of Expression 1, Expression 2, and Expression 3 below. When the physical quantity is an AC signal, the noise frequency component (Cn) has a frequency given by any one of Expression 4, Expression 5, and Expression 6 below under a condition in which the greatest common divisor, which is at least 2, of two or more frequencies including the electrical angular frequency of the motor (50) among the electrical angular frequency of the motor (50), the carrier frequency of the inverter (23), and the frequency for sampling the modulation wave used for controlling the inverter (23) does not exist.

[Math. 3]

$$|f_c \pm 6Nf_0| \cdots (1)$$
$$|Mf_s - 6Nf_0| \cdots (2)$$
$$|Mf_s - |f_c \pm 6Nf_0|| \cdots (3)$$
$$|f_0 \pm |f_c \pm 6Nf_0|| \cdots (4)$$
$$|f_0 \pm |Mf_s - 6Nf_0|| \cdots (5)$$
$$|f_0 \pm |Mf_s - |f_c \pm 6Nf_0||| \cdots (6)$$

where M and N are natural numbers.

[Countermeasure Process]

In the estimation process, when estimating that the state of the device (70) is an "abnormal state", the control unit (31) performs the countermeasure process. The countermeasure process is a process for dealing with the abnormality of the device (70). For example, the countermeasure process is an output process for outputting first information indicating that the state of the device (70) is the abnormal state.

Examples of the output process include the following first output process, second output process, and third output process, and a combination thereof. The first output process is a process for outputting the first information to a display device (not illustrated) provided in a remote controller or the like to cause the display device to display the first information. The second output process is a process for outputting the first information to a control unit (not illustrated) that controls the operation of the device (70) to cause the control unit to perform an operation for dealing with the abnormal state. The third output process is a process for uploading the first information to a data accumulation unit (not illustrated) on the cloud.

[Knowledge obtained by the Inventors]

Next, knowledge obtained by the inventors of the present application will be described. As a result of studies, the inventors of the present application have found that various noise frequency components may affect the "specific frequency component (C1) used in the estimation process". For example, the specific frequency component (C1) may be affected by a noise frequency component having a frequency corresponding to the absolute value of the sum or difference of at least two of a frequency that is an integer multiple of the electrical angular frequency of the motor (50), a frequency that is an integer multiple of the power source frequency, a frequency that is an integer multiple of the carrier frequency of the inverter (23), and a frequency that is an integer multiple of the sampling frequency for sampling the physical quantity in the calculation process.

Furthermore, as a result of intensive studies, the inventors of the present application have found that, among the various noise frequency components that may affect the specific frequency component (C1), the influence of noise frequency components below tends to be particularly significant.

(1) A noise frequency component having a frequency given by any one of Expression 1, Expression 2, and Expression 3 below when the physical quantity is a DC signal

(2) A noise frequency component having a frequency given by any one of Expression 4, Expression 5, and Expression 6 below when the physical quantity is an AC signal

[Math. 4]

$$|f_c \pm 6Nf_0| \cdots (1)$$
$$|Mf_s - 6Nf_0| \cdots (2)$$
$$|Mf_s - |f_c \pm 6Nf_0|| \cdots (3)$$
$$|f_0 \pm |f_c \pm 6Nf_0|| \cdots (4)$$
$$|f_0 \pm |Mf_s - 6Nf_0|| \cdots (5)$$
$$|f_0 \pm |Mf_s - |f_c \pm 6Nf_0||| \cdots (6)$$

where M and N are natural numbers.

The "$|Mf_s - 6Nf_0|$" given in Expressions 2 and 5 corresponds to a frequency associated with aliasing that occurs when a frequency component having a frequency that is 6 times the electrical angular frequency of the motor (50) is sampled. The "$|Mf_s - |f_c \pm 6Nf_0||$" given in Expressions 3 and 6 corresponds to a frequency associated with aliasing that occurs when a frequency component having a frequency corresponding to the difference between the "carrier frequency of the inverter (23)" and the "frequency that is 6N times the electrical angular frequency of the motor (50)" is sampled. Note that $6Nf_0$ is a spatial harmonic of the motor and has a characteristic that the amplitudes of the noise frequency components decrease as the value of N increases. Further, the intervals between the frequencies of the noise frequency components become sparse as $f_0$ increases.

In this specification, a noise frequency component having a frequency given by any one of Expressions 1 to 6 above is referred to as a "noise frequency component (Cn)".

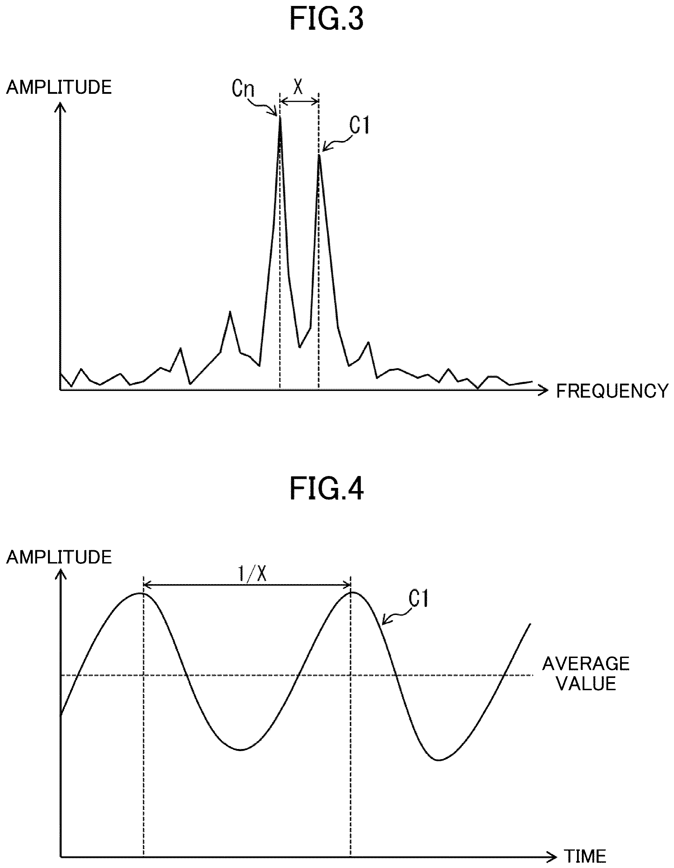

The influence of the noise frequency component (Cn) appears in the magnitude (amplitude) of the specific frequency component (C1). In other words, the noise frequency component (Cn) may cause the magnitude of the specific frequency component (C1) to vary. For example, as illustrated in Fig. 3, when the noise frequency component (Cn) is generated in the vicinity of the specific frequency component (C1), as illustrated in Fig. 4, the magnitude of the noise frequency component (Cn), which is calculated, varies in a cycle (1/X) represented by the reciprocal of the frequency difference (X) between the noise frequency component (Cn) and the specific frequency component (C1).

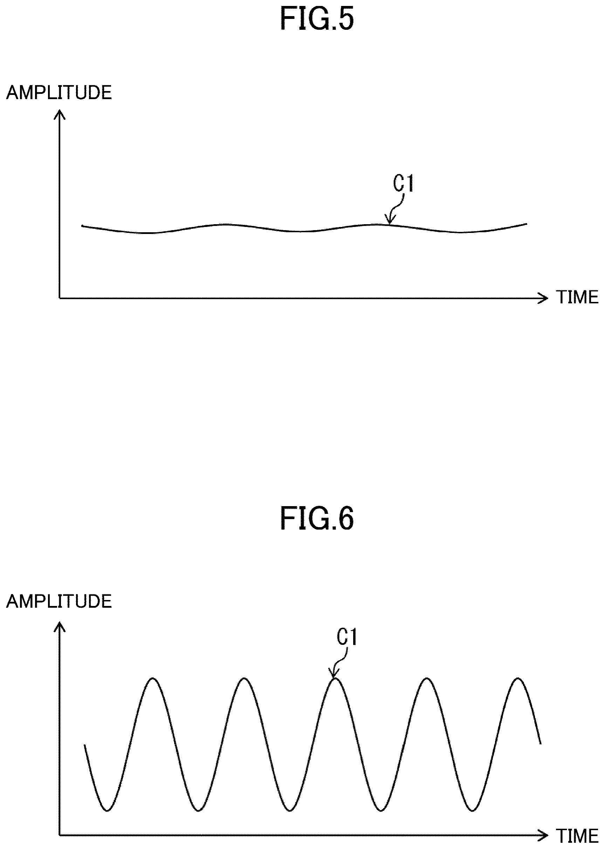

The variation in the amplitude of the specific frequency component (C1) due to the influence of the noise frequency component (Cn) tends to increase as the difference between the noise frequency component (Cn) and the specific frequency component (C1) decreases. For example, Fig. 5 illustrates the waveform of the specific frequency component (C1) in a case where the frequency difference between the noise frequency component (Cn) and the specific frequency component (C1) is relatively large, and Fig. 6 illustrates the waveform of the specific frequency component (C1) in a case where the frequency difference between the noise frequency component (Cn) and the specific frequency component (C1) is relatively small. In the example of Fig. 5, the frequency difference between the noise frequency component (Cn) and the specific frequency component (C1) is 3 Hz. In the example of Fig. 6, the frequency difference between the noise frequency component (Cn) and the specific frequency component (C1) is 0.2 Hz.

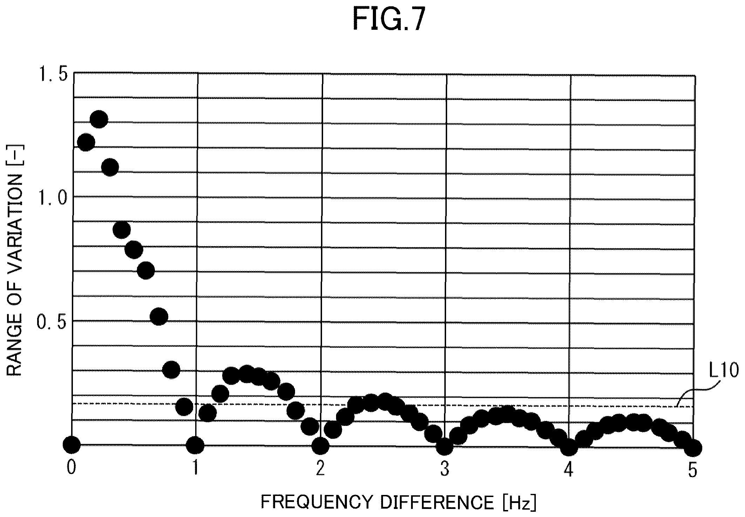

As a result of intensive studies, the inventors of the present application have found that, when the frequency difference between the noise frequency component (Cn) and the specific frequency component (C1) is 3 Hz, the "range of variation of the specific frequency component (C1) affected by the noise frequency component (Cn)" is less than or equal to 10% of the "amplitude of the specific frequency component (C1) not affected by the noise frequency component (Cn)". Fig. 7 illustrates the relationship between the frequency difference between the noise frequency component (Cn) and the specific frequency component (C1) and the range of variation of the specific frequency component (C1). In the example of Fig. 7, the range of variation of the specific frequency component (C1) is indicated by a value obtained by dividing the difference between the maximum value and the minimum value of the amplitude of the specific frequency component (C1) by 2. A broken line L10 illustrated in Fig. 7 indicates 10% of the amplitude of the specific frequency component (C1) not affected by the noise frequency component (Cn).

[Flow of Processes by Control Unit]

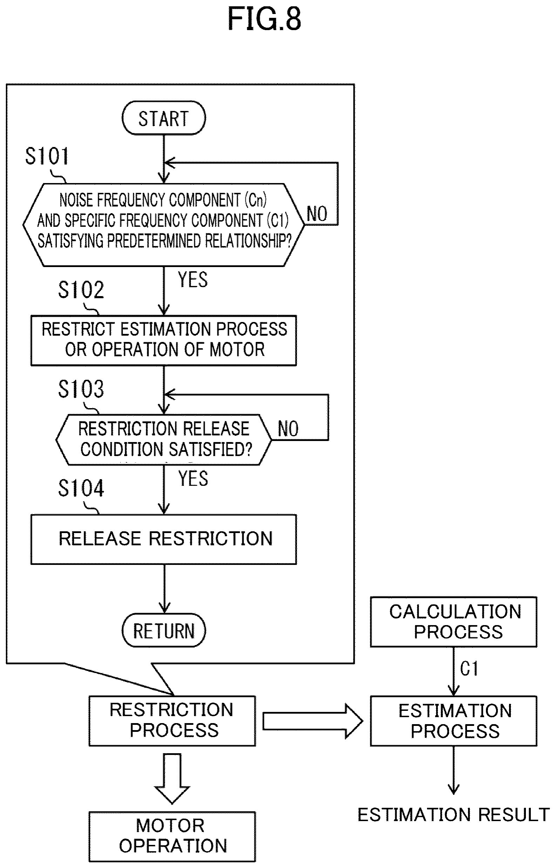

Next, the flow of the processes by the control unit (31) (specifically, the calculation process, the estimation process, and the restriction process) will be described with reference to Fig. 8.

The control unit (31) performs the calculation process for each predetermined calculation time. The calculation process is repeatedly performed, ensuring that the specific frequency component (C1) is calculated at each calculation time. For example, the calculation time is set to a time equal to or longer than the time required to calculate the specific frequency component (C1) from the physical quantity obtained from the device (70).

Then, the control unit (31) performs the estimation process for each predetermined estimation time, based on the specific frequency component (C1) calculated by the calculation process. The estimation process is repeatedly performed, ensuring that an estimation result is obtained at each estimation time. The estimation time is set to a time equal to or longer than the calculation time. For example, the estimation time is set to a time equal to or longer than the time required to estimate the state of the device (70), based on the specific frequency component (C1) calculated by the calculation process.

The control unit (31) further performs the restriction process in parallel with the calculation process and the estimation process. Specifically, the control unit (31) repeatedly performs the processing of steps (S101 to S104) illustrated in Fig. 8.

<Step (S101)>

The control unit (31) derives the noise frequency component (Cn). For example, the control unit (31) calculates the noise frequency component (Cn), based on a predetermined calculation formula (specifically, any one of Expressions 1 to 6). Further, the control unit (31) acquires the specific frequency component (C1) calculated by the calculation process. Then, the control unit (31) determines whether the noise frequency component (Cn) and the specific frequency component (C1) satisfy a predetermined relationship.

In this example, the predetermined relationship is a relationship in which the frequency difference between the noise frequency component (Cn) and the specific frequency component (C1) is less than or equal to a frequency difference threshold value. For example, the frequency difference threshold value is set to 3 Hz. The control unit (31) determines whether the frequency difference between the noise frequency component (Cn) and the specific frequency component (C1) is less than or equal to the frequency difference threshold value.

If the noise frequency component (Cn) and the specific frequency component (C1) satisfy the predetermined relationship, the processing of step (S102) is performed. For example, the processing of step (S101) is performed for each predetermined determination time. In other words, the processing of step (S101) is repeatedly performed until the noise frequency component (Cn) and the specific frequency component (C1) satisfy the predetermined relationship.

<Step (S102)>

If the noise frequency component (Cn) and the specific frequency component (C1) satisfy the predetermined relationship, the control unit (31) restricts the estimation process or the operation of the motor (50).

<Step (S103)>

Subsequently, the control unit (31) determines whether the restriction release condition is satisfied. Examples of the restriction release condition include a condition that the noise frequency component (Cn) and the specific frequency component (C1) do not satisfy the predetermined relationship, and a condition that the control unit (31) receives a release command. For example, the release command is transmitted from an operation unit (not illustrated) to the control unit (31) when an operation for releasing the restriction is input to the operation unit by an operator.

If the restriction release condition is satisfied, the processing of step (S104) is performed. For example, the processing of step (S103) is performed for each predetermined determination time. In other words, the processing of step (S103) is repeatedly performed until the restriction release condition is satisfied.

<Step (S104)>

If the restriction release condition is satisfied, the control unit (31) releases the restriction (the restriction of the estimation process or the restriction of the operation of the motor (50)).

[Specific Examples of Specific Frequency Component and Noise Frequency Component]

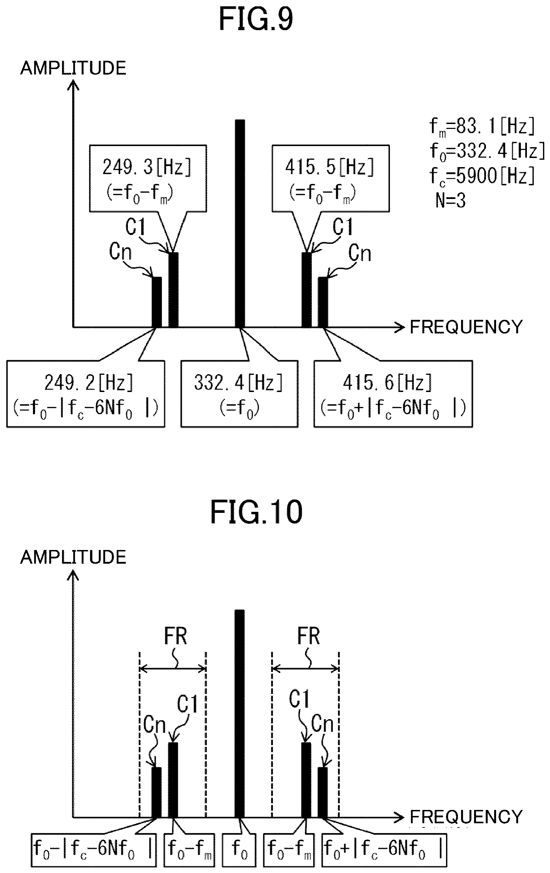

Next, specific examples of the specific frequency component and the noise frequency component will be described with reference to Fig. 9. In an example of Fig. 9, two specific frequency components (C1) are presented, the mechanical angular frequency ($f_m$) of the motor (50) is 83.1 Hz, the electrical angular frequency ($f_0$) of the motor is 332.4 Hz, and the carrier frequency ($f_c$) is 5900 Hz. The mechanical angular frequency ($f_m$) of the motor (50) corresponds to the rotational frequency of the motor (50).

In the example of Fig. 9, two specific frequency components (C1), which are symmetrical with respect to the electrical angular frequency ($f_0$) of the motor, appear, and a noise frequency component (Cn) appears in the vicinity of each of the two specific frequency components (C1). One of the specific frequency components (C1) has a frequency of 249.3 Hz, and one of the noise frequency components (Cn) located in the vicinity of the one specific frequency component (C1) has a frequency of 249.2 Hz. The other specific frequency component (C1) has a frequency of 415.5 Hz, and the other noise frequency component (Cn) located in the vicinity of the other specific frequency component (C1) has a frequency of 415.6 Hz. In this example, since the frequency difference between the noise frequency component (Cn) and the specific frequency component (C1) is 0.1 Hz, the estimation process or the operation of the motor (50) is restricted in the restriction process.

As described above, in Embodiment 1, it is possible to consider the influence of noise frequency components (Cn) having frequencies other than "frequencies that are the greatest common divisor disclosed in PTL 1 (a greatest common divisor of at least 2) and integer multiples thereof". In contrast, the abnormality diagnosis device in PTL 1 cannot consider the influence of the noise frequency components (Cn).

[Effects of Embodiment 1]

As described above, according to Embodiment 1, in the restriction process, the control unit (31) restricts the estimation process or the operation of the motor (50) when a noise frequency component (Cn) included in the physical quantity and the specific frequency component (C1) satisfy a predetermined relationship. The noise frequency component (Cn) has a frequency given by any one of Expression 1, Expression 2, and Expression 3 below when the physical quantity is a DC signal, and has a frequency given by any one of Expression 4, Expression 5, and Expression 6 below when the physical quantity is an AC signal, under a condition in which the greatest common divisor, which is at least 2, of two or more frequencies including the electrical angular frequency among the electrical angular frequency, the carrier frequency, and the frequency for sampling the modulation wave used for controlling the inverter (23) does not exist.

[Math. 5]

$$|f_c \pm 6Nf_0| \cdots (1)$$
$$|Mf_s - 6Nf_0| \cdots (2)$$
$$|Mf_s - |f_c \pm 6Nf_0|| \cdots (3)$$
$$|f_0 \pm |f_c \pm 6Nf_0|| \cdots (4)$$
$$|f_0 \pm |Mf_s - 6Nf_0|| \cdots (5)$$
$$|f_0 \pm |Mf_s - |f_c \pm 6Nf_0||| \cdots (6)$$

where M and N are natural numbers.

In the above configuration, the noise frequency component (Cn) having a frequency given by any one of Expressions 1 to 6 above is a frequency component that may affect the specific frequency component (C1). In the restriction process, accordingly, by restricting the estimation process or the operation of the motor (50) based on the relationship between the noise frequency component (Cn) and the specific frequency component (C1), it is possible to suppress erroneous estimation of the state of the device (70). In this example, it is possible to prevent the erroneous estimation that the device (70) is abnormal. Thus, it is possible to prevent the erroneous estimation that the device (70) is abnormal.

In Embodiment 1, it is possible to consider the influence of noise frequency components having frequencies other than "frequencies that are the greatest common divisor disclosed in PTL 1 (a greatest common divisor of at least 2) and integer multiples thereof". Thus, it is possible to appropriately suppress erroneous estimation of the state of the device (70).

In Embodiment 1, the predetermined relationship is a relationship in which the frequency difference between the noise frequency component (Cn) and the specific frequency component (C1) is less than or equal to a predetermined frequency difference threshold value. Thus, by restricting the estimation process or the operation of the motor (50) based on the frequency difference between the noise frequency component (Cn) and the specific frequency component (C1), it is possible to suppress erroneous estimation of the state of the device (70).

In Embodiment 1, the frequency difference threshold value is 3 Hz. Thus, it is possible to restrict the estimation process or the operation of the motor (50) when the "range of variation of the specific frequency component (C1) affected by the noise frequency component (Cn)" is greater than 10% of the "amplitude of the specific frequency component (C1) not affected by the noise frequency component (Cn)". As a result, it is possible to appropriately suppress erroneous estimation of the state of the device (70).

(Modification of Predetermined Relationship)

The predetermined relationship that it is determined in step (S101) whether the noise frequency component (Cn) and the specific frequency component (C1) satisfy is not limited to the relationship in which the frequency difference between the noise frequency component (Cn) and the specific frequency component (C1) is less than or equal to the frequency difference threshold value.

For example, as illustrated in Fig. 10, the predetermined relationship may be a relationship in which the noise frequency component (Cn) is included in a specific frequency range (FR) that is based on the frequency of the specific frequency component (C1). In step (S101), the control unit (31) may determine whether the noise frequency component (Cn) is included in the specific frequency range (FR) that is based on the frequency of the specific frequency component (C1).

The specific frequency range (FR) may be set to a frequency range centered on the frequency of the specific frequency component (C1) and having a bandwidth of 6 Hz. This setting can restrict the estimation process or the operation of the motor (50) when the "range of variation of the specific frequency component (C1) affected by the noise frequency component (Cn)" is greater than 10% of the "amplitude of the specific frequency component (C1) not affected by the noise frequency component (Cn)".

(Specific Examples of Signal)

Next, specific examples of the "signal based on the current or voltage of the motor (50)", which is an example of the physical quantity obtained from the device (70), will be described. This signal is roughly classified into a DC signal and an AC signal.

[Specific Examples of DC Signal]

Examples of the DC signal include a "signal correlated with the phase currents (iu, iv, iw) of the motor (50)", a "signal correlated with phase voltages (Vu, Vv, Vw) of the motor (50)", and a "signal correlated with electric power of the motor (50)".

Other examples of the DC signal include "currents (iγ, iδ) obtained by coordinate transformation of the phase currents (iu, iv, iw) of the motor (50) by a phase (ωi·t) of the phase currents (iu, iv, iw) of the motor (50)", "voltages (Vγ, Vδ) obtained by coordinate transformation of the phase voltages (Vu, Vv, Vw) of the motor (50) by a phase (ωv·t) of the phase voltages (Vu, Vv, Vw) of the motor (50)", "currents (iζ, iη) obtained by coordinate transformation of the phase currents (iu, iv, iw) of the motor (50) by the phase (ωv·t) of the phase voltages (Vu, Vv, Vw) of the motor (50)", and "voltages (Vζ, Vη) obtained by coordinate transformation of the phase voltages (Vu, Vv, Vw) of the motor (50) by the phase (ωi·t) of the phase currents (iu, iv, iw) of the motor (50)".

Still other examples of the DC signal include "dq-axis magnetic fluxes (λd, λq) obtained by coordinate transformation in accordance with an armature interlinkage magnetic flux by a permanent magnet" and a "magnitude λ0 of an armature interlinkage magnetic flux vector obtained by combining the armature interlinkage magnetic flux of the permanent magnet and the armature reaction".

In the following description, the "phase currents (iu, iv, iw) of the motor (50)" refer to the phase currents (iu, iv, iw) of the motor (50) detected by the phase current detection unit (41). The "phase voltages (Vu, Vv, Vw) of the motor (50)" refer to the phase voltages (Vu, Vv, Vw) of the motor (50) indicated by a voltage command value used inside the control unit (31), or the phase voltages (Vu, Vv, Vw) of the motor (50) detected by a phase voltage detection unit (not illustrated) provided in the motor drive device (20). The "electrical angular frequency (ω) of the motor (50)" refers to the electrical angular frequency (ω) of the motor (50) detected by the electrical angular frequency detection unit (42).

[1. Specific Examples of Signal Correlated with Phase Currents of Motor]

Specific examples of the signal correlated with the phase currents (iu, iv, iw) of the motor (50) include a current vector amplitude (Ia), a square value of the current vector amplitude (Ia$^2$), a phase current amplitude (I), and a phase current effective value (Irms).

The current vector amplitude (Ia) and the square value of the current vector amplitude (Ia$^2$) are examples of a value corresponding to the sum of the square values of the three phase currents (iu, iv, iw) of the motor (50). The value corresponding to the sum of the square values of the three phase currents (iu, iv, iw) of the motor (50) is an example of a value proportional to an integer power of the magnitude of the phase currents (iu, iv, iw) of the motor (50).

(1) Current Vector Amplitude

The current vector amplitude (Ia) is derived based on the phase currents (iu, iv, iw) of the motor (50). Alternatively, the current vector amplitude (Ia) may be derived based on an α-phase current (iα) and a β-phase current (iβ) obtained by transforming the phase currents (iu, iv, iw) of the motor (50) into a fixed coordinate system. Alternatively, the current vector amplitude (Ia) may be derived based on an M-axis current (iM) and a T-axis current (iT) obtained by coordinate transformation of the phase currents (iu, iv, iw) of the motor (50) by an angle based on the direction of a primary magnetic flux. Alternatively, the current vector amplitude (Ia) may be derived based on a d-axis current (id) and a q-axis current (iq) obtained by coordinate transformation of the phase currents (iu, iv, iw) of the motor (50) by an angle based on the direction of a magnetic pole position. Specifically, the current vector amplitude (Ia) can be expressed by the following equation.

[Math. 6]

$$I_a = \sqrt{i_u^2 + i_v^2 + i_w^2} = \sqrt{i_\alpha^2 + i_\beta^2} = \sqrt{i_M^2 + i_T^2} = \sqrt{i_d^2 + i_q^2}$$

(2) Square Value of Current Vector Amplitude

The square value of the current vector amplitude (Ia$^2$) is derived based on the phase currents (iu, iv, iw) of the motor (50). Alternatively, the square value of the current vector amplitude (Ia$^2$) may be derived based on an α-phase current (iα) and a β-phase current (iβ) obtained by transforming the phase currents (iu, iv, iw) of the motor (50) into a fixed coordinate system. Alternatively, the square value of the current vector amplitude (Ia$^2$) may be derived based on an M-axis current (iM) and a T-axis current (iT) obtained by coordinate transformation of the phase currents (iu, iv, iw) of the motor (50) by an angle based on the direction of a primary magnetic flux. Alternatively, the square value of the current vector amplitude ($Ia^2$) may be derived based on a d-axis current (id) and a q-axis current (iq) obtained by coordinate transformation of the phase currents (iu, iv, iw) of the motor (50) by an angle based on the direction of a magnetic pole position. Specifically, the square value of the current vector amplitude ($Ia^2$) can be expressed by the following equation.

[Math. 7]

$$I_a^2 = i_u^2 + i_v^2 + i_w^2 = i_\alpha^2 + i_\beta^2 = i_M^2 + i_T^2 = i_d^2 + i_q^2$$

(3) Phase Current Amplitude

The phase current amplitude (I) is derived based on one phase current (e.g., the U-phase current (iu)) among the phase currents (iu, iv, iw) of the motor (50) and a phase ($\omega i$) of the phase current. The phase ($\omega i$) of the phase current is derived based on, for example, the phase currents (iu, iv, iw) of the motor (50). Specifically, the phase current amplitude (I) can be expressed by the following equation.

[Math. 8]

$$I = \frac{i_u}{\cos \omega_i t}$$

(4) Phase Current Effective Value

The phase current effective value (Irms) is derived based on the phase current amplitude (I). Specifically, the phase current effective value (Irms) can be expressed by the following equation.

[Math. 9]

$$I_{rms} = \frac{I}{\sqrt{2}}$$

(5) Others

In the above description, a case where the current vector amplitude (Ia) is derived based on the three phase currents (iu, iv, iw) of the motor (50) has been described as an example. However, the current vector amplitude (Ia) may be derived based on two phase currents of the three phase currents (iu, iv, iw) of the motor (50). Alternatively, the current vector amplitude (Ia) may be derived based on the DC current of the inverter (23) detected by a DC current detection unit (e.g., a shunt resistance, not illustrated) provided in the motor drive device (20). The same applies to the square value of the current vector amplitude ($Ia^2$).

[2. Specific Examples of Signal Correlated with Phase Voltages of Motor]

Specific examples of the signal correlated with the phase voltages (Vu, Vv, Vw) of the motor (50) include a voltage vector amplitude (Va), a square value of the voltage vector amplitude ($Va^2$), a phase voltage amplitude (V), and a phase voltage effective value (Vrms).

The voltage vector amplitude (Va) and the square value of the voltage vector amplitude ($Va^2$) are examples of a value corresponding to the sum of the square values of the three phase voltages (Vu, Vv, Vw) of the motor (50). The value corresponding to the sum of the square values of the three phase voltages (Vu, Vv, Vw) of the motor (50) is an example of a value proportional to an integer power of the magnitude of the phase voltages (Vu, Vv, Vw) of the motor (50).

(1) Voltage Vector Amplitude

The voltage vector amplitude (Va) is derived based on the phase voltages (Vu, Vv, Vw) of the motor (50). Alternatively, the voltage vector amplitude (Va) may be derived based on an $\alpha$-phase voltage (V$\alpha$) and a $\beta$-phase voltage

(Vβ) obtained by transforming the phase voltages (Vu, Vv, Vw) of the motor (50) into a fixed coordinate system. Alternatively, the voltage vector amplitude (Va) may be derived based on an M-axis voltage (VM) and a T-axis voltage (VT) obtained by coordinate transformation of the phase voltages (Vu, Vv, Vw) of the motor (50) by an angle based on the direction of a primary magnetic flux. Alternatively, the voltage vector amplitude (Va) may be derived based on a d-axis voltage (Vd) and a q-axis voltage (Vq) obtained by coordinate transformation of the phase voltages (Vu, Vv, Vw) of the motor (50) by an angle based on the direction of a magnetic pole position. Specifically, the voltage vector amplitude (Va) can be expressed by the following equation.

[Math. 10]

$$V_a = \sqrt{v_u^2 + v_v^2 + v_w^2} = \sqrt{v_\alpha^2 + v_\beta^2} = \sqrt{v_M^2 + v_T^2} = \sqrt{v_d^2 + v_q^2}$$

(2) Square Value of Voltage Vector Amplitude

The square value of the voltage vector amplitude (Va$^2$) is derived based on the phase voltages (Vu, Vv, Vw) of the motor (50). Alternatively, the square value of the voltage vector amplitude (Va$^2$) may be derived based on an α-phase voltage (Vα) and a β-phase voltage (Vβ) obtained by transforming the phase voltages (Vu, Vv, Vw) of the motor (50) into a fixed coordinate system. Alternatively, the square value of the voltage vector amplitude (Va$^2$) may be derived based on an M-axis voltage (VM) and a T-axis voltage (VT) obtained by coordinate transformation of the phase voltages (Vu, Vv, Vw) of the motor (50) by an angle based on the direction of a primary magnetic flux. Alternatively, the square value of the voltage vector amplitude (Va$^2$) may be derived based on a d-axis voltage (Vd) and a q-axis voltage (Vq) obtained by coordinate transformation of the phase voltages (Vu, Vv, Vw) of the motor (50) by an angle based on the direction of a magnetic pole position. Specifically, the square value of the voltage vector amplitude (Va$^2$) can be expressed by the following equation.

[Math. 11]

$$V_a^2 = v_u^2 + v_v^2 + v_w^2 = v_\alpha^2 + v_\beta^2 = v_M^2 + v_T^2 = v_d^2 + v_q^2$$

(3) Phase Voltage Amplitude

The phase voltage amplitude (V) is derived based on one phase voltage (e.g., the U-phase voltage (Vu)) among the phase voltages (Vu, Vv, Vw) of the motor (50) and a phase (ωv) of the phase voltage. The phase (ωv) of the phase voltage is derived based on, for example, the phase voltages (Vu, Vv, Vw) of the motor (50). Specifically, the phase voltage amplitude (V) can be expressed by the following equation.

[Math. 12]

$$V = \frac{v_u}{\cos \omega_v t}$$

(4) Phase Voltage Effective Value

The phase voltage effective value (Vrms) is derived based on the phase voltage amplitude (V). Specifically, the phase voltage effective value (Vrms) can be expressed by the following equation.

[Math. 13]

$$V_{rms} = \frac{V}{\sqrt{2}}$$

(5) Others

In the above description, a case where the voltage vector amplitude (Va) is derived based on the three phase voltages (Vu, Vv, Vw) of the motor (50) has been described as an example. However, the voltage vector amplitude (Va) may be derived based on two phase voltages of the three phase voltages (Vu, Vv, Vw) of the motor (50). The same applies to the square value of the voltage vector amplitude ($Va^2$).

[3. Specific Examples of Signal Correlated with Electric Power of Motor]

Examples of the signal correlated with the electric power of the motor (50) include instantaneous power (p), instantaneous imaginary power (q), apparent power (S), active power (P), and reactive power (Q).

(1) Instantaneous Power

The instantaneous power (p) is derived based on the phase currents (iu, iv, iw) of the motor (50) and the phase voltages (Vu, Vv, Vw) of the motor (50). Alternatively, the instantaneous power (p) may be derived based on an $\alpha$-phase current (i$\alpha$) and a $\beta$-phase current (i$\beta$) obtained by transforming the phase currents (iu, iv, iw) of the motor (50) into a fixed coordinate system, and an $\alpha$-phase voltage (V$\alpha$) and a $\beta$-phase voltage (V$\beta$) obtained by transforming the phase voltages (Vu, Vv, Vw) of the motor (50) into a fixed coordinate system. Alternatively, the instantaneous power (p) may be derived based on an M-axis current (iM) and a T-axis current (iT) obtained by coordinate transformation of the phase currents (iu, iv, iw) of the motor (50) by an angle based on the direction of a primary magnetic flux, and an M-axis voltage (VM) and a T-axis voltage (VT) obtained by coordinate transformation of the phase voltages (Vu, Vv, Vw) of the motor (50) by an angle based on the direction of a primary magnetic flux. Alternatively, the instantaneous power (p) may be derived based on a d-axis current (id) and a q-axis current (iq) obtained by coordinate transformation of the phase currents (iu, iv, iw) of the motor (50) by an angle based on the direction of a magnetic pole position, and a d-axis voltage (Vd) and a q-axis voltage (Vq) obtained by coordinate transformation of the phase voltages (Vu, Vv, Vw) of the motor (50) by an angle based on the direction of a magnetic pole position. Specifically, the instantaneous power (p) can be expressed by the following equation.

[Math. 14]

$$p = v_u i_u + v_v i_v + v_w i_w = v_\alpha i_\alpha + v_\beta i_\beta = v_M i_M + v_T i_T = v_d i_d + v_q i_q$$

(2) Instantaneous Imaginary Power

The instantaneous imaginary power (q) is derived based on an $\alpha$-phase current (i$\alpha$) and a $\beta$-phase current (i$\beta$) obtained by transforming the phase currents (iu, iv, iw) of the motor (50) into a fixed coordinate system, and an $\alpha$-phase voltage (V$\alpha$) and a $\beta$-phase voltage (V$\beta$) obtained by transforming the phase voltages (Vu, Vv, Vw) of the motor (50) into a fixed coordinate system. Alternatively, the instantaneous imaginary power (q) may be derived based on an M-axis current (iM) and a T-axis current (iT) obtained by coordinate transformation of the phase currents (iu, iv, iw) of the motor (50) by an angle based on the direction of a primary magnetic flux, and an M-axis voltage (VM) and a T-axis voltage (VT) obtained by coordinate transformation of the phase voltages (Vu, Vv, Vw) of the motor (50) by an angle based on the direction of a primary magnetic flux. Alternatively, the instantaneous imaginary power (q) may be derived based on a d-axis current (id) and a q-axis current (iq) obtained by coordinate transformation of the phase currents (iu, iv, iw) of the motor (50) by an angle based on the direction of a magnetic pole position, and a d-axis voltage (Vd) and a q-axis voltage (Vq) obtained by coordinate transformation of the phase voltages (Vu, Vv, Vw) of the motor (50) by an angle based on the direction of a magnetic pole position. Specifically, the instantaneous imaginary power (q) can be expressed by the following equation.

[Math. 15]

$$q = v_\alpha i_\beta - v_\beta i_\alpha = v_M i_T - v_T i_M = v_d i_q - v_q i_d$$

(3) Apparent Power

The apparent power (S) is derived based on the phase voltage effective value (Vrms) and the phase current effective value (Irms). Specifically, the apparent power (S) can be expressed by the following equation.

[Math. 16]

$$S = 3V_{rms}I_{rms}$$

(4) Active Power

The active power (P) is derived based on the phase voltage effective value (Vrms), the phase current effective value (Irms), and a phase difference ($\varphi$1) between a phase voltage and a phase current. The phase difference ($\varphi$1) between a phase voltage and a phase current is a phase difference between one phase voltage (e.g., the U-phase voltage (Vu)) and one phase current (e.g., the U-phase current (iu)), and is derived based on the phase ($\omega$i) of the phase current and the phase ($\omega$v) of the phase voltage. Specifically, the active power (P) can be expressed by the following equation.

[Math. 17]

$$P = 3V_{rms}I_{rms} \cos \varphi_1$$

(5) Reactive Power

The reactive power (Q) is derived based on the phase voltage effective value (Vrms), the phase current effective value (Irms), and a phase difference ($\varphi$1) between a phase voltage and a phase current. The phase difference ($\varphi$1) between a phase voltage and a phase current is, for example, a phase difference between the U-phase voltage (Vu) and the U-phase current (iu), and is derived based on the phase ($\omega$i) of the phase current and the phase ($\omega$v) of the phase voltage. Specifically, the reactive power (Q) can be expressed by the following equation.

[Math. 18]

$$Q = -3V_{rms}I_{rms} \sin \varphi_1$$

[4. Currents Obtained by Coordinate Transformation of Phase Currents by Phase of Phase Currents]

The currents (i$\gamma$, i$\delta$) obtained by coordinate transformation of the phase currents (iu, iv, iw) of the motor (50) by the phase ($\omega$i·t) of the phase currents (iu, iv, iw) of the motor (50) can be expressed by the following equation.

[Math. 19]

$$\begin{bmatrix} i_\gamma \\ i_\delta \end{bmatrix} = k \begin{bmatrix} \cos \omega_i t & \cos\left(\omega_i t - \dfrac{2}{3}\pi\right) & \cos\left(\omega_i t - \dfrac{4}{3}\pi\right) \\ -\sin \omega_i t & -\sin\left(\omega_i t - \dfrac{2}{3}\pi\right) & -\sin\left(\omega_i t - \dfrac{4}{3}\pi\right) \end{bmatrix} \begin{bmatrix} i_u \\ i_v \\ i_w \end{bmatrix}$$

[5. Voltages Obtained by Coordinate Transformation of Phase Voltages by Phase of Phase Voltages]

The voltages (V$\gamma$, V$\delta$) obtained by coordinate transformation of the phase voltages (Vu, Vv, Vw) of the motor (50) by the phase ($\omega$v·t) of the phase voltages (Vu, Vv, Vw) of the motor (50) can be expressed by the following equation.

[Math. 20]

$$\begin{bmatrix} v_\gamma \\ v_\delta \end{bmatrix} = k \begin{bmatrix} \cos \omega_v t & \cos\left(\omega_v t - \dfrac{2}{3}\pi\right) & \cos\left(\omega_v t - \dfrac{4}{3}\pi\right) \\ -\sin \omega_v t & -\sin\left(\omega_v t - \dfrac{2}{3}\pi\right) & -\sin\left(\omega_v t - \dfrac{4}{3}\pi\right) \end{bmatrix} \begin{bmatrix} v_u \\ v_v \\ v_w \end{bmatrix}$$

[6. Currents Obtained by Coordinate Transformation of Phase Currents by Phase of Phase Voltages]

The currents (iζ, iη) obtained by coordinate transformation of the phase currents (iu, iv, iw) of the motor (50) by the phase (ωv·t) of the phase voltages (Vu, Vv, Vw) of the motor (50) can be expressed by the following equation.

[Math. 21]

$$\begin{bmatrix} i_\zeta \\ i_\eta \end{bmatrix} = k \begin{bmatrix} \cos \omega_v t & \cos\left(\omega_v t - \dfrac{2}{3}\pi\right) & \cos\left(\omega_v t - \dfrac{4}{3}\pi\right) \\ -\sin \omega_v t & -\sin\left(\omega_v t - \dfrac{2}{3}\pi\right) & -\sin\left(\omega_v t - \dfrac{4}{3}\pi\right) \end{bmatrix} \begin{bmatrix} i_u \\ i_v \\ i_w \end{bmatrix}$$

[7. Voltages Obtained by Coordinate Transformation of Phase Voltages by Phase of Phase Currents]

The voltages (Vζ, Vη) obtained by coordinate transformation of the phase voltages (Vu, Vv, Vw) of the motor (50) by the phase (ωi·t) of the phase currents (iu, iv, iw) of the motor (50) can be expressed by the following equation.

[Math. 22]

$$\begin{bmatrix} v_\zeta \\ v_\eta \end{bmatrix} = k \begin{bmatrix} \cos \omega_i t & \cos\left(\omega_i t - \dfrac{2}{3}\pi\right) & \cos\left(\omega_i t - \dfrac{4}{3}\pi\right) \\ -\sin \omega_i t & -\sin\left(\omega_i t - \dfrac{2}{3}\pi\right) & -\sin\left(\omega_i t - \dfrac{4}{3}\pi\right) \end{bmatrix} \begin{bmatrix} v_u \\ v_v \\ v_w \end{bmatrix}$$

[8. dq-Axis Magnetic Fluxes and Magnitude of Armature Interlinkage Magnetic Flux Vector]

The dq-axis magnetic fluxes (λd, λq) obtained by coordinate transformation in accordance with an armature interlinkage magnetic flux by a permanent magnet and the magnitude λ0 of an armature interlinkage magnetic flux vector obtained by combining the armature interlinkage magnetic flux of the permanent magnet and the armature reaction can be expressed by the following equations. In the following equations, "Ld" is a d-axis inductance and "Lq" is a q-axis inductance.

[Math. 23]

$$\begin{bmatrix} \lambda_d \\ \lambda_q \end{bmatrix} = \begin{bmatrix} L_d & 0 \\ 0 & L_q \end{bmatrix} \begin{bmatrix} i_d \\ i_q \end{bmatrix} + \begin{bmatrix} \Lambda_a \\ 0 \end{bmatrix}$$

$$\lambda_0 = \sqrt{\lambda_d^2 + \lambda_q^2}$$

[9. Other Examples of DC Signal]

The DC signal may be a DC signal obtained by performing three-phase to two-phase transformation on a phase current, a phase voltage, a line current, or a line voltage of the motor (50) and further performing rotational coordinate transformation thereon. For example, the DC signal may be a d-axis current and a q-axis current obtained by performing rotational coordinate transformation on an $\alpha$-axis current and a $\beta$-axis current, which are obtained by three-phase to two-phase transformation of the phase current of the motor (50), at an angle based on the direction of a magnetic pole of a rotor of the motor (50). Alternatively, the DC signal may be an M-axis current and a T-axis current obtained by performing rotational coordinate transformation on an $\alpha$-axis current and a $\beta$-axis current at an angle based on the direction of a primary magnetic flux of the rotor of the motor (50).

The DC signal may be electric power input to the converter (21) of the motor drive device (20), electric power output from the converter (21), electric power output from the DC unit (22), a current flowing between the converter (21) and the DC unit (22), a current flowing between the DC unit (22) and the inverter (23), or the like.

[Specific Examples of AC Signal]

Examples of the AC signal include the "phase currents (iu, iv, iw) of the motor (50)", the "phase voltages (Vu, Vv, Vw) of the motor (50)", and "interlinkage magnetic fluxes ($\Psi$fu, $\Psi$fv, $\Psi$fw) of the respective phases".

The interlinkage magnetic fluxes ($\Psi$fu, $\Psi$fv, $\Psi$fw) of the respective phases can be expressed by the following expressions.

[Math. 24]

$$\psi_{fu} = \frac{\sqrt{2}}{3}\lambda_0 \cos\theta$$

$$\psi_{fv} = \frac{\sqrt{2}}{3}\lambda_0 \cos\left(\theta - \frac{2}{3}\pi\right)$$

$$\psi_{fw} = \frac{\sqrt{2}}{3}\lambda_0 \cos\left(\theta + \frac{2}{3}\pi\right)$$

Other examples of the AC signal include a current, a voltage, and an interlinkage magnetic flux of fixed coordinates obtained by three-phase to two-phase transformation of the AC signal described above.

Alternatively, the AC signal may be a line current, a line voltage, or the like of the motor (50). Alternatively, the AC signal may be a two-phase AC current (e.g., an $\alpha$-axis current and a $\beta$-axis current) or a two-phase AC voltage obtained by three-phase to two-phase transformation of a phase current, a phase voltage, a line current, or a line voltage. The AC current may be a current flowing between a commercial power source system (specifically, the AC power source (60)) and the converter (21) of the motor drive device (20).

(Specific Examples of Specific Frequency Component)

Next, specific examples of the specific frequency component will be described.

For example, when the physical quantity is a DC signal, the frequency of the specific frequency component (C1) is at least one of 1 time, 1/3 times, and 2/3 times the mechanical angular frequency of the motor (50). When the physical quantity is an AC signal, the frequency of the specific frequency component (C1) is at least one of a frequency obtained by adding a predetermined frequency to the electrical angular frequency of the motor (50), a frequency obtained by subtracting a predetermined frequency from the electrical angular frequency of the motor (50), and a frequency that is 3 times the electrical angular frequency of the motor (50). The predetermined frequency is any one of 1 time, 1/3 times, and 2/3 times the mechanical angular frequency of the motor (50).

By setting the frequency of the specific frequency component (C1) as described above, it is possible to estimate various states (particularly, an abnormality) of the device (70).

(Various States of Device)

The various states of the device (70) will now be described. Examples of the state of the device (70) include oil seal failure of a compression chamber, insulation deterioration of the motor (50), bearing wear, dilution, liquid compression, unbalance, and blockage of a flow path. These states of the device (70) are examples of abnormalities of the device (70).

[1. Oil Seal Failure of Compression Chamber]

The oil seal failure of the compression chamber is a state that can occur when the motor (50) is the "motor (50) mounted in the compressor", and is a state in which the lubricating oil for sealing the compression chamber (not illustrated) in the compressor is insufficient.
When the physical quantity is a DC signal, if the oil seal failure of the compression chamber occurs, the frequency component corresponding to a frequency that is 1 time the mechanical angular frequency of the motor (50) tends to decrease. Thus, when the physical quantity is a DC signal, it is possible to estimate the "oil seal failure of the compression chamber" by setting the frequency of the specific frequency component (C1) to a frequency that is "1 time the mechanical angular frequency of the motor (50)".
When the physical quantity is an AC signal, if the oil seal failure of the compression chamber occurs, the frequency component corresponding to a frequency obtained by adding a frequency that is "1 time the mechanical angular frequency of the motor (50)" to the electrical angular frequency of the motor (50), and the frequency component corresponding to a frequency obtained by subtracting a frequency that is "1 time the mechanical angular frequency of the motor (50)" from the electrical angular frequency of the motor (50) tend to decrease. Thus, when the physical quantity is an AC signal, it is possible to estimate the "oil seal failure of the compression chamber" by setting the frequency of the specific frequency component (C1) to a frequency obtained by adding a frequency that is "1 time the mechanical angular frequency of the motor (50)" to the electrical angular frequency of the motor (50) or a frequency obtained by subtracting a frequency that is "1 time the mechanical angular frequency of the motor (50)" from the electrical angular frequency of the motor (50).

[2. Insulation Deterioration of Motor]

The insulation deterioration of the motor (50) is a state (abnormality) in which the insulation performance of the motor (50) is insufficient. When the deterioration of the insulation performance of the motor (50) progresses, the insulation level of the motor (50) falls below an allowable level.
When the physical quantity is an AC signal, if the insulation deterioration of the motor (50) occurs, the frequency component corresponding to a frequency that is 3 times the electrical angular frequency of the motor (50) tends to increase. Thus, when the physical quantity is an AC signal, it is possible to estimate the "insulation deterioration of the motor (50)" by setting the frequency of the specific frequency component (C1) to a frequency that is "3 times the electrical angular frequency of the motor (50)".

[3. Bearing Wear]

The bearing wear is a state (abnormality) in which the shaft rotationally driven by the motor (50) or the bearing of the shaft wears.
When the physical quantity is a DC signal, if the bearing wear occurs, the frequency components corresponding to frequencies that are 1/3 times and 2/3 times the mechanical angular frequency of the motor (50) tend to increase. Thus, when the physical quantity is a DC signal, it is possible to estimate the "bearing wear" by setting the frequency of the specific frequency component (C1) to a frequency that is "at least one of 1/3 times and 2/3 times the mechanical angular frequency of the motor (50)".
When the physical quantity is an AC signal, if the bearing wear occurs, a frequency component corresponding to a frequency obtained by adding a frequency that is "1/3 times the mechanical angular frequency of the motor (50)" to the electrical angular frequency of the motor (50), a frequency component corresponding to a frequency obtained by subtracting a frequency that is "1/3 times the mechanical angular frequency of the motor (50)" from the electrical angular frequency of the motor (50), a frequency component corresponding to a frequency obtained by adding a frequency that is "2/3 times the mechanical angular frequency of the motor (50)" to the electrical angular frequency of the motor (50), and a frequency component corresponding to a frequency obtained by subtracting a frequency that is "2/3 times the mechanical angular frequency of the motor (50)" from the electrical angular frequency of the motor (50) tend to increase. Thus, when the physical quantity is an AC signal, it is possible to estimate the "bearing wear" by setting the frequency of the specific frequency component (C1) to a frequency obtained by adding a frequency that is "1/3 times the mechanical angular frequency of the motor (50)" to the electrical angular frequency of the motor (50), a frequency obtained by subtracting a frequency that is "1/3 times the mechanical angular frequency of the motor (50)" from the electrical angular frequency of the motor (50), a frequency obtained by adding a frequency that is "2/3 times the mechanical angular frequency of the motor (50)" to the electrical angular frequency of the motor (50), or a frequency obtained by subtracting a frequency that is "2/3 times the mechanical angular frequency of the motor (50)" from the electrical angular frequency of the motor (50).

[4. Dilution]

The dilution is a state (abnormality) that can occur when the motor (50) is the "motor (50) mounted in the compressor", and is a state in which the oil concentration of the compressor is insufficient. If the dilution occurs, friction in a bearing portion (not illustrated) in the compressor increases, leading to wear of the bearing portion. If the dilution occurs, furthermore, the lubricating oil in a sliding portion (not illustrated) in the compressor runs out and causes friction, leading to surface roughness of the sliding portion.

When the physical quantity is a DC signal, if the dilution occurs, the frequency component corresponding to a frequency that is 1 time the mechanical angular frequency of the motor (50) tends to decrease. Thus, when the physical quantity is a DC signal, it is possible to estimate the "dilution" by setting the frequency of the specific frequency component (C1) to a frequency that is "1 time the mechanical angular frequency of the motor (50)".

When the physical quantity is an AC signal, if the dilution occurs, the frequency component corresponding to a frequency obtained by adding a frequency that is "1 time the mechanical angular frequency of the motor (50)" to the electrical angular frequency of the motor (50), and the frequency component corresponding to a frequency obtained by subtracting a frequency that is "1 time the mechanical angular frequency of the motor (50)" from the electrical angular frequency of the motor (50) tend to decrease. Thus, when the physical quantity is an AC signal, it is possible to estimate the "dilution" by setting the frequency of the specific frequency component (C1) to a frequency obtained by adding a frequency that is "1 time the mechanical angular frequency of the motor (50)" to the electrical angular frequency of the motor (50) or a frequency obtained by subtracting a frequency that is "1 time the mechanical angular frequency of the motor (50)" from the electrical angular frequency of the motor (50).

[5. Liquid Compression]

The liquid compression is a state (abnormality) that can occur when the motor (50) is the "motor (50) mounted in the compressor", and is a state in which a liquid fluid is sucked into a compression chamber (not illustrated) of the compressor. The occurrence of the liquid compression leads to metal fatigue, breakage, and the like of components constituting the compression chamber.

When the physical quantity is a DC signal, if the liquid compression occurs, the frequency component corresponding to a frequency that is 1 time the mechanical angular frequency of the motor (50) tends to increase. Thus, when the physical quantity is a DC signal, it is possible to estimate the "liquid compression" by setting the frequency of the specific frequency component (C1) to a frequency that is "1 time the mechanical angular frequency of the motor (50)".

When the physical quantity is an AC signal, if the liquid compression occurs, the frequency component corresponding to a frequency obtained by adding a frequency that is "1 time the mechanical angular frequency of the motor (50)" to the electrical angular frequency of the motor (50), and the frequency component corresponding to a frequency obtained by subtracting a frequency that is "1 time the mechanical angular frequency of the motor (50)" from the electrical angular frequency of the motor (50) tend to increase. Thus, when the physical quantity is an AC signal, it is possible to estimate the "liquid compression" by setting the frequency of the specific frequency component (C1) to a frequency obtained by adding a frequency that is "1 time the mechanical angular frequency of the motor (50)" to the electrical angular frequency of the motor (50) or a frequency obtained by subtracting a frequency that is "1 time the mechanical angular frequency of the motor (50)" from the electrical angular frequency of the motor (50).

[6. Unbalance]

The unbalance is a state (abnormality) that can occur when the motor (50) is the "motor (50) that drives blades of a fan", and is a state in which unbalance occurs in a plurality of blades provided in the fan. For example, the unbalance is caused by different degrees of deformation, breakage, contamination, and frost formation in each of the plurality of blades.

When the physical quantity is an AC signal, if the unbalance occurs, the frequency component corresponding to a frequency obtained by adding a frequency that is "1 time the mechanical angular frequency of the motor (50)" to the electrical angular frequency of the motor (50), and the frequency component corresponding to a frequency obtained by subtracting a frequency that is "1 time the mechanical angular frequency of the motor (50)" from the electrical angular frequency of the motor (50) tend to increase. Thus, when the physical quantity is an AC signal, it is possible to estimate the "unbalance" by setting the frequency of the specific frequency component (C1) to a frequency obtained by adding a frequency that is "1 time the mechanical angular frequency of the motor (50)" to the electrical angular frequency of the motor (50) or a frequency obtained by subtracting a frequency that is "1 time the mechanical angular frequency of the motor (50)" from the electrical angular frequency of the motor (50).

[7. Blockage of Flow Path]

The blockage of the flow path is a state (abnormality) that can occur when the motor (50) is the "motor (50) that drives the blades of the fan", and is a state in which the flow path provided with the fan is blocked. The blockage of the flow path is caused by, for example, clogging of a filter (not illustrated) with which the flow path is provided together with the fan. If the blockage of the flow path occurs, the reaction force at the time of air blowing is disturbed by the variation in load due to the turbulent flow, and the speed changes.

When the physical quantity is a DC signal, if the blockage of the flow path occurs, a frequency component having a peak around a frequency that is 1 time the mechanical angular frequency of the motor (50) tends to vary. Thus, when the physical quantity is a DC signal, it is possible to estimate the "blockage of the flow path" by setting the frequency of the specific frequency component (C1) to a frequency that is "1 time the mechanical angular frequency of the motor (50)".

When the physical quantity is an AC signal, if the blockage of the flow path occurs, the electrical angular frequency of the motor (50) tends to vary. Thus, when the physical quantity is an AC signal, it is possible to estimate the "blockage of the flow path" by setting the frequency of the specific frequency component (C1) to the electrical angular frequency of the motor (50).

(Specific Examples of Estimation Process)

Next, specific examples of the estimation process will be described. Examples of the estimation process include the following four estimation processes (first to fourth estimation processes). Hereinafter, a case where the estimation process is performed based on the amplitude of the specific frequency component (C1) will be described as an example. In the following description, the "specific frequency component (C1)" refers to the "amplitude of the specific frequency component (C1)".

[First Estimation Process]

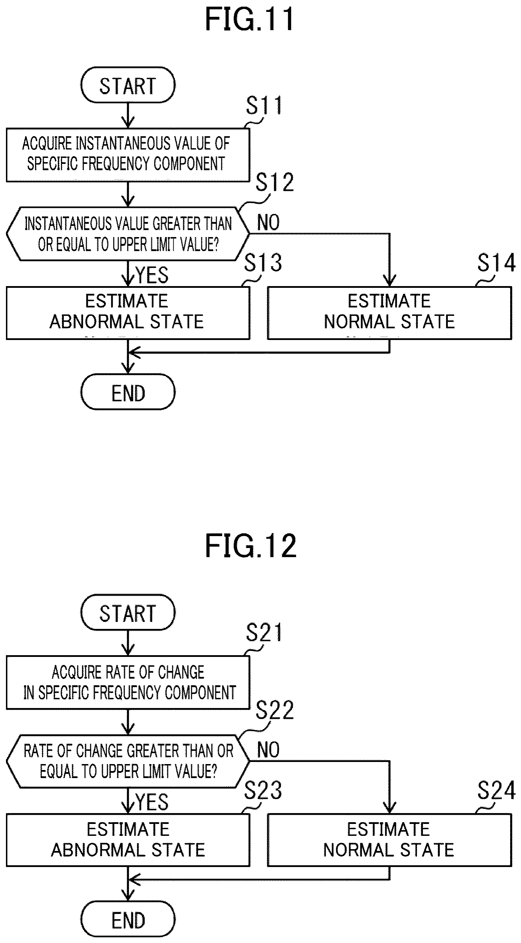

First, the first estimation process will be described with reference to Fig. 11. In the first estimation process, the control unit (31) estimates whether the state of the device (70) is the abnormal state, based on an instantaneous value of the specific frequency component (C1). Specifically, the control unit (31) performs the following process (step (S11) to step (S13)) for each predetermined detection cycle.

<Step (S11)>

The control unit (31) acquires an instantaneous value of the specific frequency component (C1).

<Step (S12)>

Subsequently, the control unit (31) determines whether the instantaneous value of the specific frequency component (C1) acquired in step (S11) is greater than or equal to a predetermined upper limit value. The upper limit value is an example of a threshold value used in the estimation process. If the instantaneous value of the specific frequency component (C1) is greater than or equal to the upper limit value, the processing of step (S13) is performed. On the other hand, if not, the processing of step (S14) is performed.

<Step (S13)>

If the instantaneous value of the specific frequency component (C1) is greater than or equal to the upper limit value in step (S12), the control unit (31) estimates that the state of the device (70) is the abnormal state. Then, the control unit (31) outputs an estimation result indicating that the state of the device (70) is the abnormal state.

<Step (S14)>

On the other hand, if the instantaneous value of the specific frequency component (C1) is not greater than or equal to the upper limit value in step (S12), the control unit (31) estimates that the state of the device (70) is a normal state. Then, the control unit (31) outputs an estimation result indicating that the state of the device (70) is the normal state.

[Second Estimation Process]

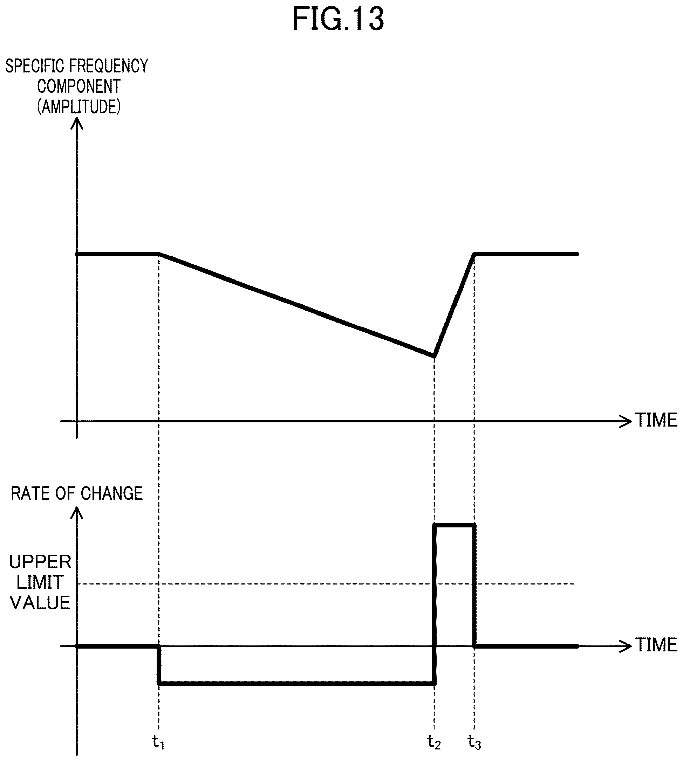

The second estimation process will be described with reference to Figs. 12 and 13. In the second estimation process, the control unit (31) estimates whether the state of the device (70) is the abnormal state, based on a rate of change in the specific frequency component (C1). Specifically, the control unit (31) repeatedly performs the following process (step (S21) to step (S23)) for each predetermined detection cycle.

<Step (S21)>

The control unit (31) acquires a rate of change in the specific frequency component (C1). For example, the control unit (31) derives the rate of change in the specific frequency component (C1) by differentiating the instantaneous value of the specific frequency component (C1) with respect to time. In an example of Fig. 13, the rate of change in the specific frequency component (C1) changes at each of times (t1, t2, and t3).

<Step (S22)>

The control unit (31) determines whether the rate of change in the specific frequency component (C1) acquired in step (S21) is greater than or equal to a predetermined upper limit value. The upper limit value is an example of a threshold value used in the estimation process. If the rate of change in the specific frequency component (C1) is greater than or equal to the upper limit value, the processing of step (S23) is performed. On the other hand, if not, the processing of step (S24) is performed. In the example of Fig. 13, the rate of change in the specific frequency component (C1) is greater than or equal to the upper limit value at the time (t2).

<Step (S23)>

If the rate of change in the specific frequency component (C1) is greater than or equal to the upper limit value in step (S22), the control unit (31) estimates that the state of the device (70) is the abnormal state. Then, the control unit (31) outputs an estimation result indicating that the state of the device (70) is the abnormal state.

<Step (S24)>

On the other hand, if the rate of change in the specific frequency component (C1) is not greater than or equal to the upper limit value in step (S22), the control unit (31) estimates that the state of the device (70) is the normal state. Then, the control unit (31) outputs an estimation result indicating that the state of the device (70) is the normal state.

[Third Estimation Process]

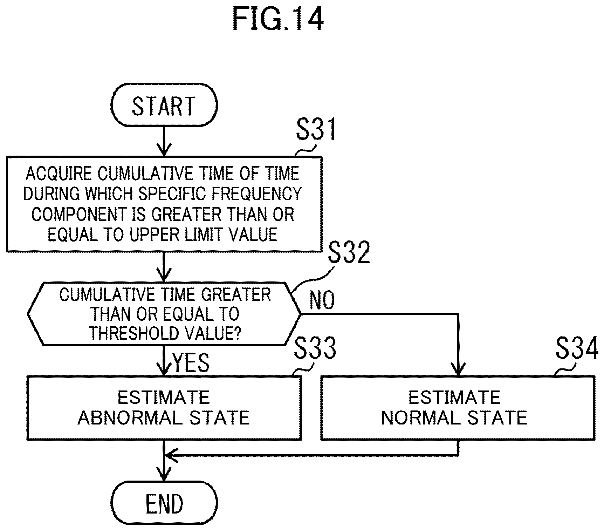

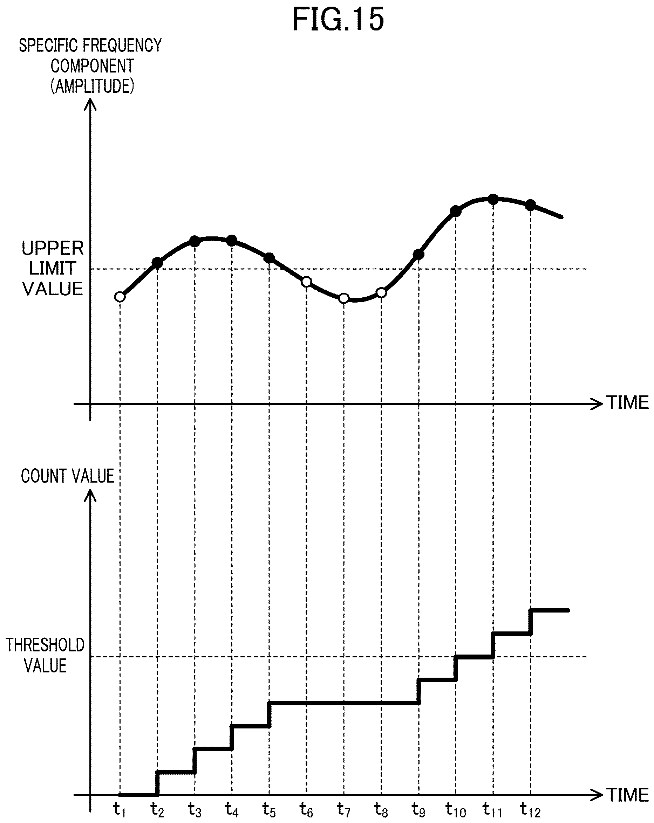

The third estimation process will be described with reference to Figs. 14 and 15. In the third estimation process, the control unit (31) estimates whether the state of the device (70) is the abnormal state, based on a cumulative time obtained by summing the time during which the specific frequency component (C1) is greater than or equal to an upper limit value. Specifically, the control unit (31) repeatedly performs the following process (step (S31) to step (S33)) for each predetermined detection cycle.

<Step (S31)>

The control unit (31) acquires a cumulative value (cumulative time) of the time during which the specific frequency component (C1) is greater than or equal to an upper limit value. The upper limit value is an example of a threshold value used in the estimation process.

For example, the control unit (31) acquires an instantaneous value of the specific frequency component (C1) that is a representative value in the detection cycle, and determines whether the instantaneous value of the specific frequency component (C1) is greater than or equal to the upper limit value. Then, the control unit (31) increments the count value when the instantaneous value of the specific frequency component (C1) is greater than or equal to the upper limit value, and does not increment the count value when the instantaneous value of the specific frequency component (C1) is not greater than or equal to the upper limit value. The count value corresponds to the cumulative value (cumulative time) of the time during which the specific frequency component (C1) is greater than or equal to the upper limit value. For example, a value obtained by multiplying the count value by the time corresponding to the detection cycle is the cumulative time.

In an example of Fig. 15, the third estimation process is performed for each of times (t1 to t12), and the count value is incremented at the times (t2 to t5 and t9 to t12) among the times (t1 to t12).

<Step (S32)>

Subsequently, the control unit (31) determines whether the cumulative time (the count value in this example) acquired in step (S31) exceeds a predetermined threshold value. The threshold value is an example of a threshold value used in the estimation process. If the cumulative time exceeds the threshold value, the processing of step (S33) is performed. On the other hand, if not, the processing of step (S34) is performed. In the example of Fig. 15, the control unit (31) determines that the count value exceeds the threshold value at the time (t11).

<Step (S33)>

If the cumulative time exceeds the threshold value in step (S32), the control unit (31) estimates that the state of the device (70) is the abnormal state. Then, the control unit (31) outputs an estimation result indicating that the state of the device (70) is the abnormal state.

<Step (S34)>

On the other hand, if the cumulative time does not exceed the threshold value in step (S32), the control unit (31) estimates that the state of the device (70) is the normal state. Then, the control unit (31) outputs an estimation result indicating that the state of the device (70) is the normal state.

[Fourth Estimation Process]

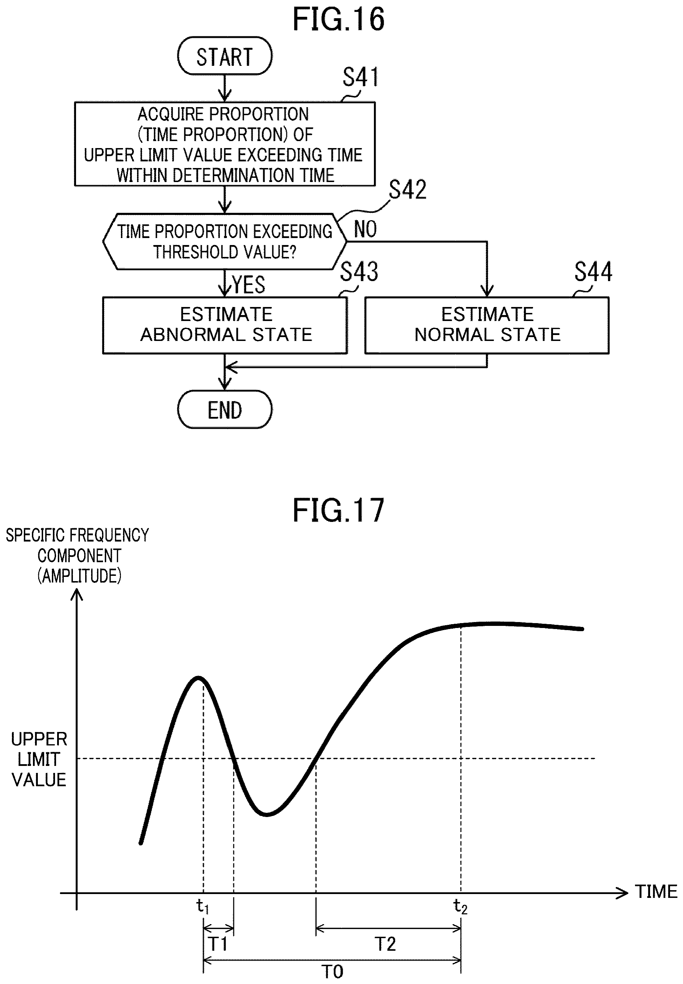

The fourth estimation process will be described with reference to Figs. 16 and 17. In the fourth estimation process, the control unit (31) estimates whether the state of the device (70) is the abnormal state, based on the proportion (time proportion) of the time during which the specific frequency component (C1) is greater than or equal to a predetermined upper limit value within a predetermined determination time. Specifically, the control unit (31) repeatedly performs the following process (step (S41) to step (S43)) for each predetermined detection cycle.

<Step (S41)>

The control unit (31) acquires the proportion (time proportion) of the time during which the specific frequency component (C1) is greater than or equal to an upper limit value within a determination time. The upper limit value is an example of a threshold value used in the estimation process.

For example, the control unit (31) stores the specific frequency component (C1) within a determination period (at least a period corresponding to the determination time) ending at the current time. Then, based on the stored specific frequency component (C1), the control unit (31) derives a time (upper limit value exceeding time) during which the specific frequency component (C1) is greater than or equal to the upper limit value within the determination period ending at the current time and having a duration corresponding to the determination time, and divides the upper limit value exceeding time by the determination time to derive the time proportion. In an example of Fig. 17, a time (t2) is the current time, a period from a time (t1) to the time (t2) is the determination period, a time (T1) and a time (T2) are the upper limit value exceeding times, and a value obtained by dividing the sum of the time (T1) and the time (T2) by a determination time (T0) is the time proportion.

<Step (S42)>

Subsequently, the control unit (31) determines whether the time proportion (the proportion of the time during which the specific frequency component (C1) is greater than or equal to the upper limit value within the determination time) acquired in step (S41) exceeds a predetermined threshold value. The threshold value is an example of a threshold value used in the estimation process. If the time proportion exceeds the threshold value, the processing of step (S43) is performed. On the other hand, if not, the processing of step (S44) is performed.

<Step (S43)>

If the time proportion exceeds the threshold value in step (S42), the control unit (31) estimates that the state of the device (70) is the abnormal state. Then, the control unit (31) outputs an estimation result indicating that the state of the device (70) is the abnormal state.

<Step (S44)>

On the other hand, if the time proportion does not exceed the threshold value in step (S42), the control unit (31) estimates that the state of the device (70) is the normal state. Then, the control unit (31) outputs an estimation result indicating that the state of the device (70) is the normal state.

In the above description of the estimation process, a case where the specific frequency component (C1) is compared with the upper limit value has been described as an example, but is not intended to be limiting. For example, the specific frequency component (C1) may be compared with a predetermined lower limit value. That is, in the above description, "greater than or equal to the upper limit value" may be interpreted as "less than or equal to the lower limit value". Alternatively, the specific frequency component (C1) may be compared with a predetermined allowable range. That is, in the above description, "greater than or equal to the upper limit value" may be interpreted as "out of the allowable range".

(Specific Examples of First Restriction Process)

Next, specific examples of the first restriction process will be described. Examples of the "process for restricting the estimation process" performed in the first restriction process include the following five estimation restriction processes (first to fifth estimation restriction processes).

[First Estimation Restriction Process]

First, the first estimation restriction process will be described. The first estimation restriction process is a process for prohibiting (stopping) the execution of the estimation process. In the first estimation restriction process, the control unit (31) stops the estimation process and outputs a predetermined estimation result. Thus, the estimation process is directly restricted so that a predetermined estimation result is output. As described above, it is possible to prevent an erroneous estimation result from being obtained, thereby enabling suppression of the erroneous estimation of the state of the device (70).

[Second Estimation Restriction Process]

Next, the second estimation restriction process will be described. The second estimation restriction process is a process for correcting the estimation result obtained by the estimation process. In the second estimation restriction process, while continuing the estimation process, the control unit (31) corrects the estimation result obtained by the estimation process to a "predetermined estimation result". Thus, the estimation process is directly restricted so that a predetermined estimation result is output. As described above, it is possible to prevent an erroneous estimation result from being obtained, thereby enabling suppression of the erroneous estimation of the state of the device (70).

[Third Estimation Restriction Process]

Next, the third estimation restriction process will be described. The third estimation restriction process is a process for prohibiting (stopping) the execution of the calculation process. In the third estimation restriction process, the control unit (31) stops the calculation process, and sets the specific frequency component (C1) used in the estimation process to a "predetermined specific frequency component (C1)" so that a predetermined estimation result is obtained in the estimation process. Thus, the estimation process is indirectly restricted so that a predetermined estimation result is output. As described above, it is possible to prevent an erroneous estimation result from being obtained, thereby enabling suppression of the erroneous estimation of the state of the device (70).

[Fourth Estimation Restriction Process]

Next, the fourth estimation restriction process will be described. The fourth estimation restriction process is a process for correcting the specific frequency component (C1) calculated by the calculation process. In the fourth estimation restriction process, while continuing the calculation process, the control unit (31) corrects the specific frequency component (C1) calculated by the calculation process to a "predetermined specific frequency component (C1)" so that a predetermined estimation result is obtained in the estimation process. Thus, the estimation process is indirectly restricted so that a predetermined estimation result is output. As described above, it is possible to prevent an erroneous estimation result from being obtained, thereby enabling suppression of the erroneous estimation of the state of the device (70).

[Fifth Estimation Restriction Process]

Next, the fifth estimation restriction process will be described. The fifth estimation restriction process is a process performed when the control unit (31) estimates the state of the device (70) based on the result of the comparison between the amplitude of the specific frequency component (C1) and a predetermined threshold value in the estimation process, and is a process for correcting at least one of the threshold value and the amplitude of the specific frequency component (C1). In the fifth estimation restriction process, the control unit (31) corrects the threshold value used in the estimation process to a "predetermined threshold value" so that a predetermined estimation result is obtained in the estimation process. Alternatively, in the fifth estimation restriction process, the control unit (31) corrects the specific frequency component (C1) used in the estimation process to a "predetermined specific frequency component (C1)" so that a predetermined estimation result is obtained in the estimation process. Thus, the estimation process is directly restricted so that a predetermined estimation result is output. As described above, it is possible to prevent an erroneous estimation result from being obtained, thereby enabling suppression of the erroneous estimation of the state of the device (70).

(Specific Examples of Second Restriction Process)

Next, specific examples of the second restriction process will be described. Examples of the "process for restricting the operation of the motor (50)" performed in the second restriction process include the following two operation restriction processes (first and second operation restriction processes).

[First Operation Restriction Process]

First, the first operation restriction process will be described. The first operation restriction process is a process for changing an operation condition of the motor (50) so that no erroneous estimation is performed in the estimation process. The process for changing the operation condition of the motor (50) is a process for changing at least one of the carrier frequency, the sampling frequency for sampling the physical quantity in the calculation process, and the mechanical angular frequency of the motor (50). In the first operation restriction process, the control unit (31) changes the operation condition of the motor (50) including at least one of the carrier frequency, the sampling frequency, and the mechanical angular frequency of the motor (50) so that no erroneous estimation is performed in the estimation process.

By changing the operation condition of the motor (50) in this way, it is possible to prevent the noise frequency component (Cn) and the specific frequency component (C1) from satisfying the predetermined relationship. Thus, it is possible to suppress the variation in the magnitude of the specific frequency component (C1) due to the influence of the noise frequency component (Cn), thereby enabling suppression of the erroneous estimation of the state of the device (70).

[Second Operation Restriction Process]

Next, the second operation restriction process will be described. The second operation restriction process is a process for prohibiting the operation of the motor (50) under an operation condition in which the noise frequency component (Cn) and the specific frequency component (C1) satisfy the predetermined relationship. In the second operation restriction process, the control unit (31) prohibits the operation of the motor (50) when the operation condition of the motor (50) is an "operation condition in which the noise frequency component (Cn) and the specific frequency component (C1) satisfy the predetermined relationship", and permits the operation of the motor (50) otherwise.

In this way, by prohibiting the operation of the motor (50) under the operation condition in which the noise frequency component (Cn) and the specific frequency component (C1) satisfy the predetermined relationship, it is possible to prevent an erroneous estimation result from being obtained. Thus, it is possible to suppress erroneous estimation of the state of the device (70).

(Modification of Embodiment 1)

A drive system (10) according to a modification of Embodiment 1 is different from the drive system (10) according to Embodiment 1 in the restriction process by the control unit (31). Other configurations and processes of the drive system (10) according to the modification of Embodiment 1 are similar to the configurations and processes of the drive system (10) according to Embodiment 1.

In the restriction process according to the modification of Embodiment 1, the control unit (31) restricts the estimation process or the operation of the motor (50) when the noise frequency component (Cn) and the specific frequency component (C1) satisfy a predetermined relationship. If a predetermined restriction release condition is satisfied after the restriction of the estimation process or the operation of the motor (50) is started, the control unit (31) releases the restriction of the estimation process or the operation of the motor (50) after a predetermined standby release condition is satisfied.

The standby release condition will be described in detail below.

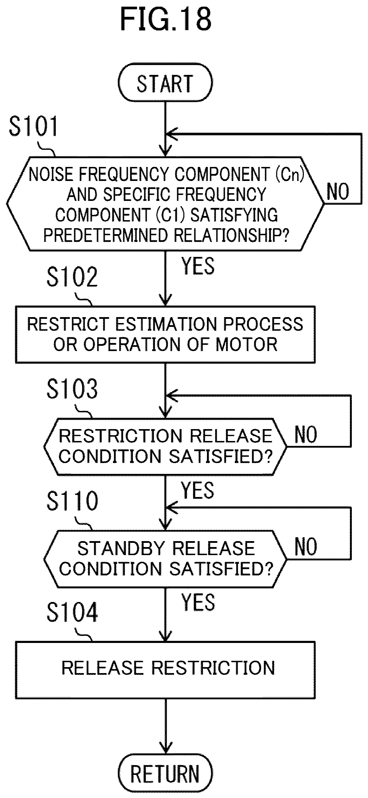

As illustrated in Fig. 18, in the restriction process according to the modification of Embodiment 1, step (S110) is performed between step (S104) and step (S103).

<Step (S110)>

If the predetermined restriction release condition is satisfied in step (S103), the control unit (31) determines whether a standby release condition is satisfied. If the standby release condition is satisfied, the processing of step (S104) is performed. For example, the processing of step (S110) is performed for each predetermined determination time. In other words, the processing of step (S110) is repeatedly performed until the standby release condition is satisfied.

[Effects of Modification of Embodiment 1]

In the modification of Embodiment 1, effects similar to those of Embodiment 1 can be obtained.

In the modification of Embodiment 1, furthermore, it is possible to release the restriction (the restriction of the estimation process or the restriction of the motor (50)) after stabilizing the specific frequency component (C1) used in the estimation process, compared to a case where the restriction (the restriction of the estimation process or the restriction of the motor (50)) is released after the restriction release condition is satisfied without waiting for the standby release condition to be satisfied. Thus, it is possible to suppress erroneous estimation of the state of the device (70) after the restriction is released.

(Specific Examples of Standby Release Condition)

Next, specific examples of the standby release condition will be described. Examples of the standby release condition include the following three standby release conditions (first to third standby release conditions).

[First Standby Release Condition]

First, the first standby release condition will be described. The first standby release condition is a condition that a predetermined time elapses from a time point at which the restriction release condition is satisfied. When the restriction release condition is satisfied, the control unit (31) releases the restriction of the estimation process or the operation of the motor (50) after a predetermined time elapses. Specifically, when the restriction release condition is satisfied, the control unit (31) starts to measure an elapsed time. When the elapsed time reaches the predetermined time, the control unit (31) releases the restriction of the estimation process or the operation of the motor (50). The predetermined time is set to, for example, a time longer than the time required for a feature quantity used to estimate the state of the device to change from the unsteady state to the steady state. It is sufficient that the feature quantity be calculated from a physical quantity obtained from the device (70) within a predetermined period. For example, the feature quantity may be the specific frequency component (C1).

[Second Standby Release Condition]

Next, the second standby release condition will be described. The second standby release condition is a condition that the number of consecutive times the restriction release condition is satisfied reaches a predetermined number of times. The control unit (31) repeatedly determines whether the restriction release condition is satisfied. When the restriction release condition is satisfied, the control unit (31) releases the restriction of the estimation process or the operation of the motor (50) after the number of consecutive times the restriction release condition is satisfied reaches a predetermined number of times. Specifically, when the restriction release condition is satisfied, the control unit (31) starts to count the number of consecutive times the restriction release condition is satisfied. When the number of consecutive times the restriction release condition is satisfied reaches a predetermined number of times, the control unit (31) releases the restriction of the estimation process or the operation of the motor (50). The predetermined number of times is set to, for example, a number of times greater than the number of consecutive times the restriction release condition is satisfied measured until the feature quantity changes from the unsteady state to the steady state.

[Third Standby Release Condition]

Next, the third standby release condition will be described. The third standby release condition is a condition that the specific frequency component (C1) calculated by the calculation process is brought into a steady state. The control unit (31) monitors the specific frequency component (C1) calculated by the calculation process, and, when a restriction release condition is satisfied, releases the restriction of the estimation process or the operation of the motor (50) after the specific frequency component (C1) calculated by the calculation process is brought into the steady state. Specifically, when the restriction release condition is satisfied, the control unit (31) determines whether the specific frequency component (C1) calculated by the calculation process is in the steady state. When the control unit (31) determines that the specific frequency component (C1) calculated by the calculation process is in the steady state, the control unit (31) releases the restriction of the estimation process or the operation of the motor (50).

The steady state of the specific frequency component (C1) is, for example, a state in which the ratio of the current value to the previous value of the moving average of the specific frequency component (C1) within a predetermined time is within a predetermined ratio. For example, the moving average within the predetermined time is the moving average for a period of one second, the previous value is the moving average acquired one second before (immediately before) the current value, and the predetermined ratio is 1%. The unsteady state of the specific frequency component (C1) is, for example, a state in which the ratio of the current value to the previous value of the moving average of the specific frequency component (C1) within a predetermined time is higher than the predetermined ratio.

(Embodiment 2)

A drive system (10) according to Embodiment 2 is different from the drive system (10) according to Embodiment 1 in the processes by the control unit (31) of the control device (30). Other configurations and processes of the drive system (10) according to Embodiment 2 are similar to the configurations and processes of the drive system (10) according to Embodiment 1.

[Processes by Control Unit]

In Embodiment 2, the control unit (31) performs a control process, a calculation process, an estimation process, a determination process, a restriction process, and a countermeasure process. The control process, the calculation process, the estimation process, and the countermeasure process are similar to those of Embodiment 1.

[Determination Process]

In the determination process, the presence or absence of noise interference is determined based on the magnitude of a periodic component included in a variable calculated based on the magnitude of the specific frequency component (C1). Examples of the "variable calculated based on the magnitude of the specific frequency component (C1)" include a value obtained by dividing a short-term moving average of the specific frequency component (C1) by a long-term moving average of the specific frequency component (C1). The short-term moving average is the moving average of the specific frequency component (C1) within a first time. The long-term moving average is the moving average of the specific frequency component (C1) within a second time. The second time is longer than the first time.

Other possible examples of the "variable calculated based on the magnitude of the specific frequency component (C1)" include an instantaneous value of the specific frequency component (C1), a square root of the sum of squares of the specific frequency component (C1), a rate of change in the specific frequency component (C 1), the ratio of the short-term moving average to the long-term moving average of the specific frequency component (C1), addition, subtraction, multiplication, and division of a plurality of specific frequency components (C1), exponentiation of the specific frequency component (C1), and a combination of at least two thereof.

When there is noise interference (specifically, when the noise component affects the specific frequency component (C1)), the magnitude (amplitude) of the specific frequency component (C1) varies. When there is noise interference, furthermore, the periodic component included in the variable calculated based on the magnitude of the specific frequency component (C1) becomes large.

For example, the control unit (31) determines that there is noise interference when the periodic component is included in the specific frequency component (C1), and determines that there is no noise interference when the periodic component is not included in the specific frequency component (C1). Specific examples of the determination process will be described in detail below.

[Restriction Process]

In the restriction process, the control unit (31) restricts the estimation process or the operation of the motor (50) if it is determined in the determination process that there is noise interference. The restriction process is a first restriction process for restricting the estimation process so that a predetermined estimation result is output, or a second restriction process for restricting the operation of the motor (50) so that no erroneous estimation is performed in the estimation process.

[Flow of Processes by Control Unit]

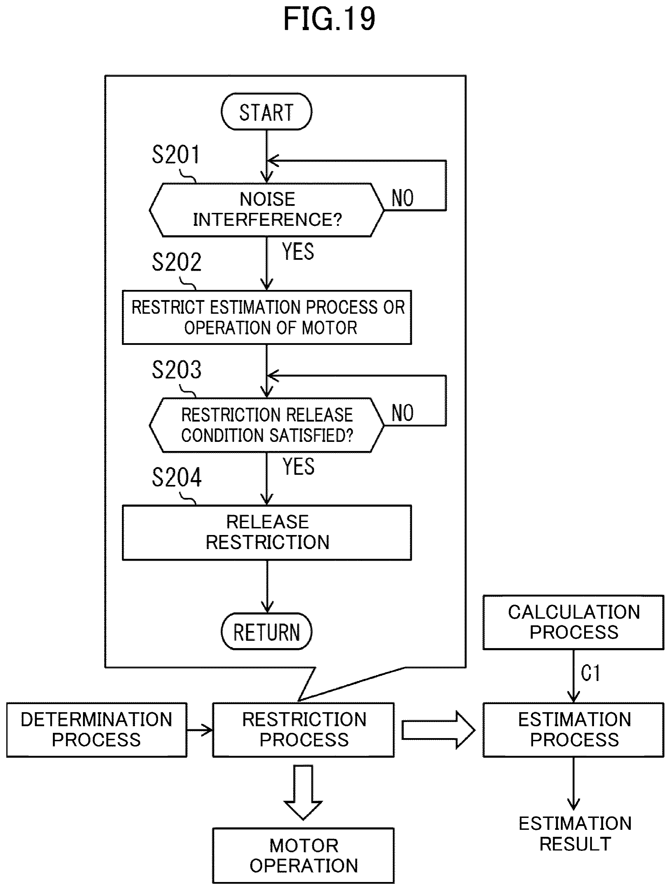

Next, the flow of the processes by the control unit (31) (specifically, the calculation process, the estimation process, the determination process, and the restriction process) will be described with reference to Fig. 19.

The control unit (31) performs the calculation process for each predetermined calculation time. The calculation process is repeatedly performed, ensuring that the specific frequency component (C1) is calculated at each calculation time.

Then, the control unit (31) performs the estimation process for each predetermined estimation time, based on the specific frequency component (C1) calculated by the calculation process. The estimation process is repeatedly performed, ensuring that an estimation result is obtained at each estimation time.

The control unit (31) further performs the determination process in parallel with the calculation process and the estimation process. Specifically, the control unit (31) performs the determination process for each predetermined determination time, based on the specific frequency component (C1) calculated by the calculation process. The determination process is repeatedly performed, ensuring that a determination result is obtained at each determination time. The determination time is set to a time equal to or longer than the time required to determine the presence or absence of noise interference based on the specific frequency component (C1) calculated by the calculation process.

The control unit (31) further performs the restriction process in parallel with the above processes (the calculation process, the estimation process, and the determination process). Specifically, the control unit (31) repeatedly performs the processing of steps (S201 to S204) illustrated in Fig. 19.

<Step (S201)>

The control unit (31) acquires a determination result by the determination process. Then, the control unit (31) determines whether there is noise interference, based on the determination result of the determination process. If there is noise interference, the processing of step (S202) is performed. For example, the processing of step (S201) is performed for each predetermined determination time. In other words, the processing of step (S201) is repeatedly performed until a determination result indicating the presence of noise interference is obtained.

<Step (S202)>

If there is noise interference, the control unit (31) restricts the estimation process or the operation of the motor (50).

<Step (S203)>

Subsequently, the control unit (31) determines whether the restriction release condition is satisfied. Examples of the restriction release condition include a condition that there is no noise interference and a condition that the control unit (31) receives a release command. For example, the release command is automatically transmitted to the control unit (31) after a predetermined time has elapsed since the restriction release condition was satisfied.

If the restriction release condition is satisfied, the processing of step (S204) is performed. For example, the processing of step (S203) is performed for each predetermined determination time. In other words, the processing of step (S203) is repeatedly performed until the restriction release condition is satisfied.

<Step (S204)>

If the restriction release condition is satisfied, the control unit (31) releases the restriction (the restriction of the estimation process or the restriction of the operation of the motor (50)).

[Effects of Embodiment 2]

As described above, in Embodiment 2, in the determination process, the control unit (31) determines the presence or absence of noise interference, based on the magnitude of a periodic component included in a variable calculated based on the magnitude of the specific frequency component (C1). In the restriction process, the control unit (31) restricts the estimation process or the operation of the motor (50) if it is determined in the determination process that there is noise interference.

In the above configuration, when the noise component affects the specific frequency component (C1), the magnitude (amplitude) of the specific frequency component (C1) varies. Accordingly, in the determination process, the presence or absence of noise interference can be appropriately determined based on the "magnitude of a periodic component included in a variable calculated based on the magnitude of the specific frequency component (C1)". In the restriction process, by restricting the estimation process or the operation of the motor (50) based on the determination result by the determination process, it is possible to suppress erroneous estimation of the state of the device (70).

In Embodiment 2, it is possible to consider the influence of noise frequency components having frequencies other than "frequencies that are the greatest common divisor disclosed in PTL 1 (a greatest common divisor of at least 2) and integer multiples thereof". Thus, it is possible to appropriately suppress erroneous estimation of the state of the device (70).

(Specific Examples of Determination Process)

Next, specific examples of the determination process will be described. Examples of the determination process include the following seven determination processes (first to seventh determination processes).

[First Determination Process]

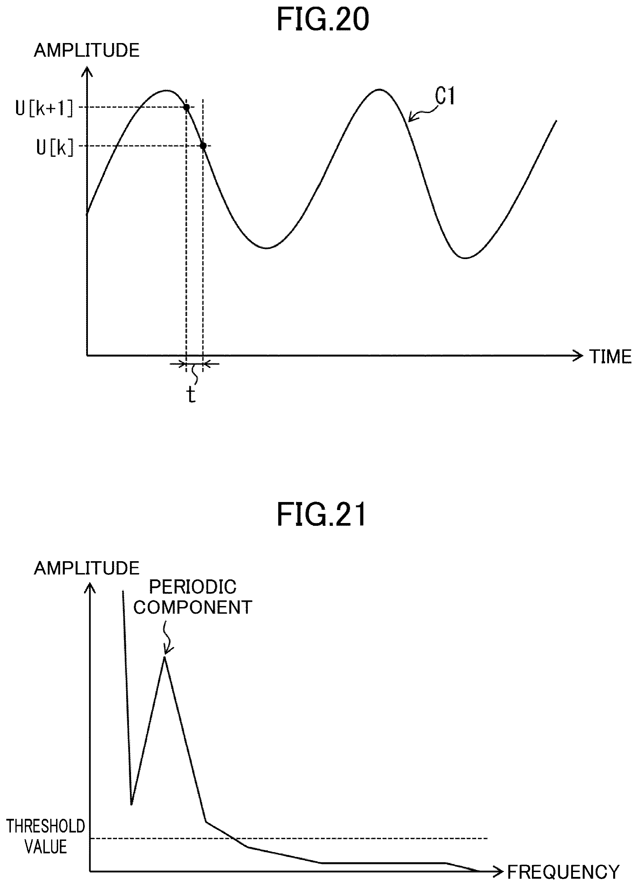

First, the first determination process will be described with reference to Fig. 20. In the first determination process, the control unit (31) determines the presence or absence of noise interference, based on the average value of the absolute values of the amounts of variation (amounts of variation per unit time) of the specific frequency component (C1) within a predetermined time.

Specifically, the control unit (31) acquires an instantaneous value of the specific frequency component (C1) for each predetermined time (t). Then, the control unit (31) divides the difference between an "instantaneous value ($U_k$) of the specific frequency component (C1) acquired at the k-th (k is a natural number) time" and an "instantaneous value ($U_{k+1}$) of the specific frequency component (C1) acquired at the (k+1)-th time" by "time (t)" to derive an amount of variation of the specific frequency component (C1) per unit time within the predetermined time. As a result, the amount of variation of the specific frequency component (C1) per unit time within the predetermined time is derived for each predetermined time (t).

The control unit (31) averages the absolute values of the "amount of variation of the specific frequency component (C1) per unit time within the predetermined time" derived for each predetermined time (t) to derive the average value of the amounts of variation of the specific frequency component (C1) within the predetermined time (the amount of variation per unit time). It is desirable that an averaging period (a period in which the average value is derived) is set to a time equal to or longer than the cycle of the variation of the specific frequency component (C1) assumed due to noise interference. For example, the averaging period is set to 3 minutes. Then, the control unit (31) determines that there is noise interference when the derived average value of the amounts of variation of the specific frequency component (C1) within the predetermined time exceeds a threshold value, and determines that there is no noise interference otherwise. For example, by setting the threshold value to "0.24% of the average value in the averaging period of the amplitude of the specific frequency component (C1)", it is possible to determine that "there is noise interference" when the specific frequency component (C1) varies by 10% or more in a cycle of 3 minutes.

The average value of the amounts of variation (amount of variation per unit time) of the specific frequency component (C1) within the predetermined time may be derived using various filters such as a low-pass filter, or may be derived using various processes such as a moving average process.

[Second Determination Process]

Next, the second determination process will be described with reference to Fig. 21. In the second determination process, the control unit (31) determines the presence or absence of noise interference, based on the magnitude of a periodic component included in the specific frequency component (C1).

Specifically, the control unit (31) performs frequency conversion on the specific frequency component (C1), and extracts a "periodic component having the largest amplitude" among periodic components of the specific frequency component (C1). Then, the control unit (31) determines whether there is noise interference, based on the magnitude (amplitude) of the periodic component of the specific frequency component (C1). Specifically, the control unit (31) determines that there is noise interference when the amplitude of the "periodic component having the largest amplitude" in the specific frequency component (C1) exceeds a threshold value, and determines that there is no noise interference otherwise. For example, by setting the threshold value to "10% of the average value within the predetermined time", it is possible to determine that "there is noise interference" when a periodic component having a variation of 10% or more is present in the specific frequency component (C1).

[Third Determination Process]

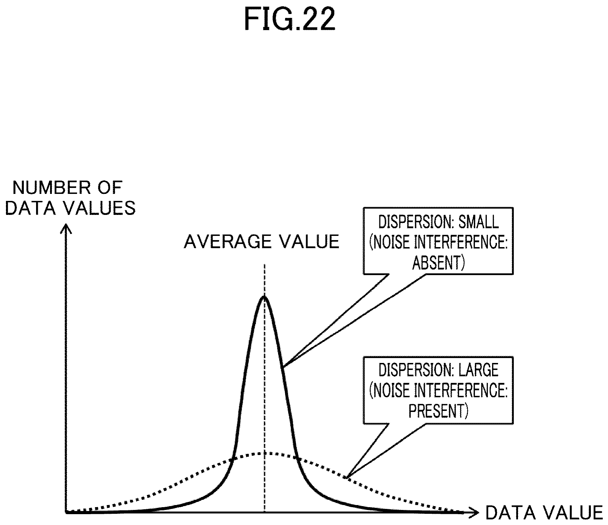

Next, the third determination process will be described with reference to Fig. 22. In the third determination process, the control unit (31) determines the presence or absence of noise interference, based on the magnitude of the standard deviation of the specific frequency component (C1) within a predetermined time. The predetermined time is desirably set to a time equal to or longer than the cycle of the variation of the specific frequency component (C1) assumed due to noise interference. For example, the predetermined time is 3 minutes.

As illustrated in Fig. 22, the distribution of the specific frequency component (C1) within the predetermined time tends to be a distribution in which data values, which are amplitude values of the specific frequency component (C1), are concentrated in the vicinity of the average value when there is no noise interference (when the influence of noise interference is relatively small), and tends to be a distribution in which the data values are dispersed rather than concentrated in the vicinity of the average value when there is noise interference (when the influence of noise interference is relatively large).

Specifically, in the third determination process, the control unit (31) derives the standard deviation of the specific frequency component (C1) within the predetermined time, based on a plurality of data values (amplitude values of the specific frequency component (C1)) obtained within the predetermined time. Then, the control unit (31) determines that there is noise interference when the standard deviation of the specific frequency component (C1) within the predetermined time exceeds a threshold value, and determines that there is no noise interference otherwise. For example, the threshold value is 7% of the average value of the amplitudes of the specific frequency component (C1) in the predetermined time. In this case, it can be determined that "there is noise interference" when a periodic component having a variation of 10% or more is present in the specific frequency component.

In the third determination process, the control unit (31) may determine the presence or absence of noise interference, based on a moving average of the standard deviation of the specific frequency component (C1) within the predetermined time. Specifically, the control unit (31) may determine that there is noise interference when the moving average value of the standard deviation of the specific frequency component (C1) within the predetermined time exceeds a threshold value, and determine that there is no noise interference otherwise.

[Fourth Determination Process]

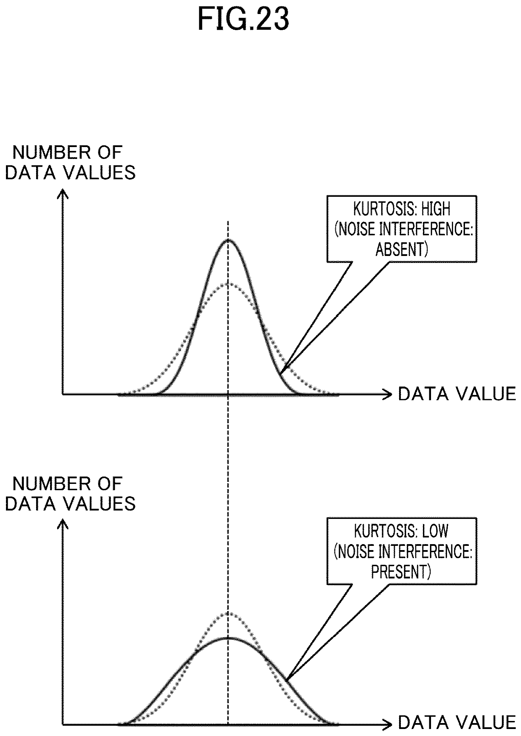

Next, the fourth determination process will be described with reference to Fig. 23. In the fourth determination process, the control unit (31) determines the presence or absence of noise interference, based on the kurtosis of the distribution of the specific frequency component (C1) within a predetermined time. The predetermined time is desirably set to a time equal to or longer than the cycle of the variation of the specific frequency component (C1) assumed due to noise interference.

As illustrated in Fig. 23, the distribution of the specific frequency component (C1) within the predetermined time tends to have a relatively high kurtosis when there is no noise interference (when the influence of noise interference is relatively small), and tends to have a relatively low kurtosis when there is noise interference (when the influence of noise interference is relatively large).

Specifically, in the fourth determination process, the control unit (31) derives the kurtosis of the distribution of the specific frequency component (C1) within the predetermined time, based on a plurality of data values (amplitude values of the specific frequency component (C1)) obtained within the predetermined time. Then, the control unit (31) determines that there is noise interference when the kurtosis of the distribution of the specific frequency component (C1) within the predetermined time falls below a predetermined value, and determines that there is no noise interference otherwise. For example, the predetermined value (kurtosis threshold value) is "-1.5".

[Fifth Determination Process]

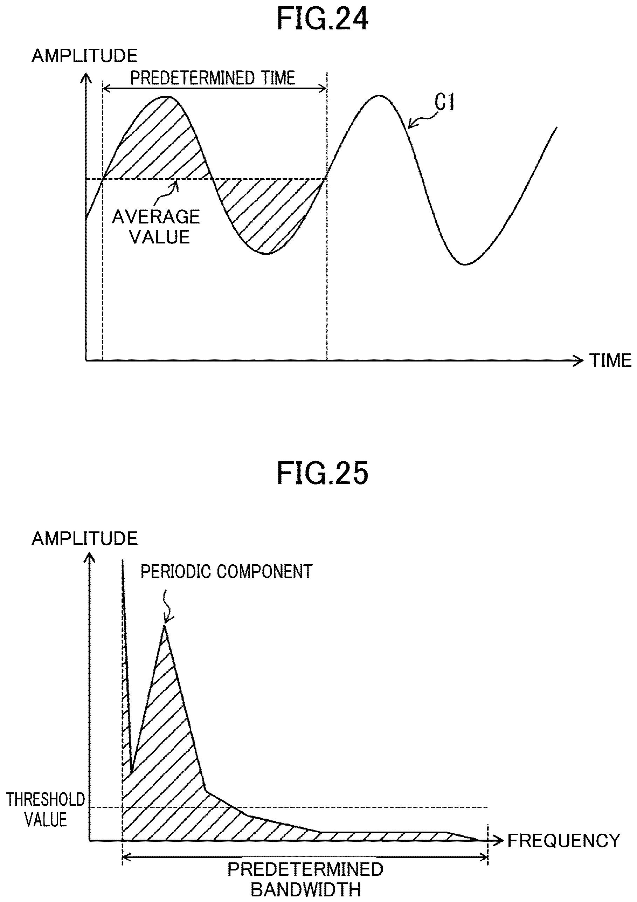

Next, the fifth determination process will be described with reference to Fig. 24. In the fifth determination process, the control unit (31) determines the presence or absence of noise interference, based on the cumulative value of the absolute values of differences between the specific frequency component (C1) and the average value within a predetermined time. The average value is an average value of the specific frequency component (C1) within a predetermined time. In an example of Fig. 24, the cumulative value of the absolute values of differences between the specific frequency component (C1) and the average value within the predetermined time corresponds to the area of hatched regions. The predetermined time is desirably set to a time equal to or longer than the cycle of the variation of the specific frequency component (C1) assumed due to noise interference. For example, the predetermined time is 3 minutes.

Specifically, in the fifth determination process, the control unit (31) derives the average value of the specific frequency component (C1) within the predetermined time, based on a plurality of data values (amplitude values of the specific frequency component (C1)) obtained within the predetermined time. Subsequently, the control unit (31) derives the absolute value of the difference between each of a plurality of data values (amplitude values of the specific frequency component (C1)) obtained within the predetermined time and the average value, and adds together the absolute values to derive the cumulative value of the absolute values of the differences between the specific frequency component (C1) and the average value within the predetermined time. Then, the control unit (31) determines that there is noise interference when the cumulative value of the absolute values of the differences between the specific frequency component (C1) and the average value within the predetermined time exceeds a threshold value, and determines that there is no noise interference otherwise. For example, the threshold value is set to "11% of the average value of the amplitudes of the specific frequency component (C1) in the predetermined time" when the absolute value of the difference between the average value and each of a plurality of data values (amplitude values of the specific frequency component (C1)) obtained in the predetermined time is calculated and the resulting absolute values are added together every second. In this case, it can be determined that "there is noise interference" when a periodic component having a variation of 10% or more is present in the specific frequency component (C1).

[Sixth Determination Process]

Next, the sixth determination process will be described with reference to Fig. 25. In the sixth determination process, the control unit (31) determines the presence or absence of noise interference, based on the cumulative value of the amplitudes of a frequency component in a predetermined bandwidth excluding 0 Hz of the spectrum of a periodic component included in the specific frequency component (C1). In an example of Fig. 25, the cumulative value of the amplitudes of the frequency component in the predetermined bandwidth of the spectrum of the periodic component included in the specific frequency component (C1) corresponds to the area of a hatched region.
Specifically, in the sixth determination process, the control unit (31) performs frequency conversion on the specific frequency component (C1) to extract a periodic component of the specific frequency component (C1). Subsequently, the control unit (31) adds together the amplitude values for each frequency in the predetermined bandwidth of the periodic component of the specific frequency component (C1) to derive a cumulative value of the amplitude values for each frequency of the periodic component. Then, the control unit (31) determines that there is noise interference when the cumulative value of the amplitude values for each frequency of the periodic component of the specific frequency component (C1) exceeds a threshold value, and determines that there is no noise interference otherwise. For example, the threshold value is 10% of the average value of the amplitudes of the specific frequency component (C1) in the predetermined time. In this case, it can be determined that "there is noise interference" when a periodic component having a variation of 10% or more is present in the specific frequency component (C1).

[Seventh Determination Process]

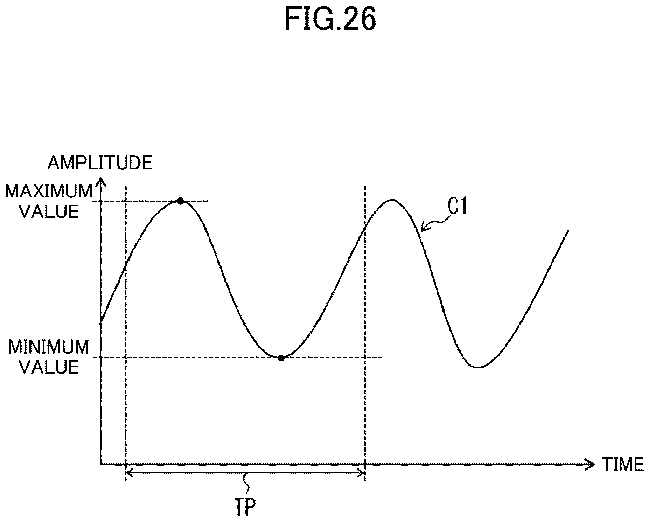

Next, the seventh determination process will be described with reference to Fig. 26. In the seventh determination process, the control unit (31) determines the presence or absence of noise interference, based on the magnitude of the difference between a maximum value and a minimum value of the specific frequency component (C1) within a predetermined period (TP). The predetermined period (TP) is desirably set to a time equal to or longer than the cycle of the variation of the specific frequency component (C1) assumed due to noise interference. For example, the predetermined period (TP) is 3 minutes.
Specifically, the control unit (31) acquires an instantaneous value of the specific frequency component (C1) within the predetermined period (TP), and derives the difference between the maximum value and the minimum value of the specific frequency component (C1) within the predetermined period (TP). As a result, the difference between the maximum value and the minimum value of the specific frequency component (C1) within the predetermined period (TP) is derived for each predetermined period (TP). Then, the control unit (31) determines that there is noise interference when the difference between the maximum value and the minimum value of the specific frequency component (C1) within the predetermined period (TP) exceeds a threshold value, and determines that there is no noise interference otherwise. For example, by setting the threshold value to "20% of the average value of the specific frequency component (C1) in the predetermined period (TP)", it is possible to determine that "there is noise interference" when a periodic component having a variation of 10% or more is present in the specific frequency component (C1).

(Modification of Embodiment 2)

A drive system (10) according to a modification of Embodiment 2 is different from the drive system (10) according to Embodiment 2 in the restriction process by the control unit (31). Other configurations and processes of the drive system (10) according to the modification of Embodiment 2 are similar to the configurations and processes of the drive system (10) according to Embodiment 2.
In the restriction process according to the modification of Embodiment 2, the control unit (31) restricts the estimation process or the operation of the motor (50) when it is determined in the determination process that there is noise interference. If a predetermined restriction release condition is satisfied after the restriction of the estimation process or the operation of the motor (50) is started, the control unit (31) releases the restriction of the estimation process or the operation of the motor (50) after a predetermined standby release condition is satisfied. The standby release condition according to the modification of Embodiment 2 is similar to the standby release condition according to the modification of Embodiment 1.

[Effects of Modification of Embodiment 2]

In the modification of Embodiment 2, effects similar to those of Embodiment 2 can be obtained.

In the modification of Embodiment 2, furthermore, it is possible to release the restriction (the restriction of the estimation process or the restriction of the motor (50)) after stabilizing the specific frequency component (C1) used in the estimation process, compared to a case where the restriction (the restriction of the estimation process or the restriction of the motor (50)) is released after the restriction release condition is satisfied without waiting for the standby release condition to be satisfied. Thus, it is possible to suppress erroneous estimation of the state of the device (70) after the restriction is released.

(Refrigeration System)

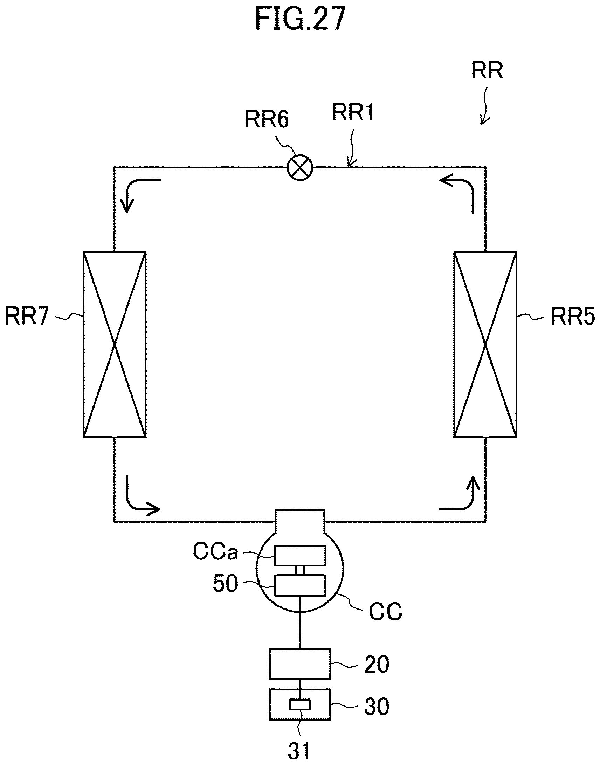

Fig. 27 illustrates a configuration of a refrigeration system (RR). The refrigeration system (RR) includes a refrigerant circuit (RR1) filled with a refrigerant, a motor drive device (20), and a control device (30). The motor drive device (20) and the control device (30) illustrated in Fig. 27 are the motor drive device (20) and the control device (30) according to Embodiment 1 or Embodiment 2.

The refrigerant circuit (RR1) includes a compressor (CC), a radiator (RR5), a decompression mechanism (RR6), and an evaporator (RR7). In this example, the decompression mechanism (RR6) is an expansion valve. The refrigerant circuit (RR1) performs a vapor compression refrigeration cycle.

The compressor (CC) includes a compression mechanism (CCa) and a motor (50). The compression mechanism (CCa) is coupled to the motor (50) by a shaft. The motor (50) rotationally drives the shaft to rotationally drive the compression mechanism (CCa). The motor drive device (20) drives the motor (50). The control device (30) determines the state of the refrigeration system (RR) in which the compressor (CC) including the motor (50) is mounted.

In the refrigeration cycle, the refrigerant discharged from the compressor (CC) dissipates heat in the radiator (RR5). The refrigerant flowing out of the radiator (RR5) is decompressed in the decompression mechanism (RR6) and evaporated in the evaporator (RR7). The refrigerant flowing out of the evaporator (RR7) is sucked into the compressor (CC).

In this example, the refrigeration system (RR) is an air conditioner. The air conditioner may be a cooling dedicated machine or a heating dedicated machine. Alternatively, the air conditioner may be an air conditioner that switches between cooling and heating. In this case, the air conditioner includes a switching mechanism (e.g., a four-way switching valve) that switches the circulation direction of the refrigerant. Alternatively, the refrigeration system (RR) may be a water heater, a chiller unit, a cooling apparatus for cooling inside air, or the like. The cooling apparatus cools air inside a refrigerator, a freezer, a container, or the like.

(Fan System)

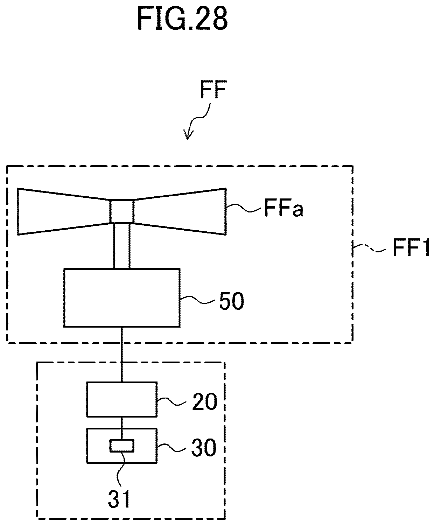

Fig. 28 illustrates a configuration of a fan system (FF). The fan system (FF) includes a fan (FF1), a motor drive device (20), and a control device (30). The motor drive device (20) and the control device (30) illustrated in Fig. 28 are the motor drive device (20) and the control device (30) according to Embodiment 1 or Embodiment 2.

The fan (FF1) is provided in a flow path (not illustrated). The fan (FF1) includes a rotor (FFa) having blades, and a motor (50). The rotor (FFa) is coupled to the motor (50) by a shaft. The motor (50) rotationally drives the shaft to rotationally drive the rotor (FFa). The motor drive device (20) drives the motor (50). The control device (30) estimates the state of the fan system (FF) in which the motor (50) is mounted. The state of the fan system (FF) estimated by the control device (30) includes blockage of the flow path in which the fan (FF1) is provided (a state in which the flow path is blocked).

(Other Embodiments)

In the above description, the state of the device (70) may be the state of the device (70) as a whole, or may be the state of some elements included in the device (70). For example, when the device (70) is an "outdoor unit in which a compressor (CC) including a motor (50) is mounted", the state of the device (70) may be the state of the outdoor unit, the state of the compressor (CC), the state of the motor (50), or the state of any other element of the outdoor unit.

In the above description, the signal based on the current or voltage of the motor (50) has been described as an example of the physical quantity obtained from the device (70), but is not intended to be limiting. For example, the physical quantity may be a signal indicating vibration of the device (70) or a signal indicating sound of the device (70). The signal indicating the vibration of the device (70) may be acquired by a vibration sensor (not illustrated) provided in the device (70).

The signal indicating the sound of the device (70) may be acquired by a sound sensor (not illustrated) provided in the device (70).

In the above description, a case where the presence or absence of an abnormality of the device (70) is estimated in the estimation process has been described as an example, but is not intended to be limiting.

For example, in the estimation process, the control unit (31) may estimate the degree of wear of a shaft (not illustrated) rotationally driven by the motor (50) or a bearing (not illustrated) of the shaft. In this case, the control unit (31) may estimate the degree of wear of the shaft or the bearing in accordance with the specific frequency component (C1), which is obtained by the calculation process, so that the degree of wear increases as the specific frequency component (C1) increases. Examples of the "predetermined estimation result" output when the estimation process for estimating the degree of wear is restricted include an estimation result indicating that the degree of wear of the device (70) is unknown and an estimation result indicating that the estimation process is prohibited (stopped). The degree of wear is an example of the degree of deterioration.

In the estimation process, the control unit (31) may estimate the remaining life of the motor (50). In this case, the control unit (31) may estimate the remaining life of the motor (50) in accordance with the feature quantity, which is obtained by the calculation process, so that the remaining life decreases as the feature quantity increases. Examples of the "predetermined estimation result" output when the estimation process for estimating the remaining life is restricted include an estimation result indicating that the remaining life of the device (70) is unknown and an estimation result indicating that the estimation process is prohibited (stopped). The remaining life is an example of the degree of deterioration.

In the above description, a band-pass filter that extracts a signal in a frequency band including the frequency of the specific frequency component (C1) may be used in the calculation process. In addition, the calculation process may involve band-pass filter processing for extracting a signal in a frequency band including the frequency of the specific frequency component (C1).

In the above description, various filters such as a Kalman filter may be used to extract a periodic component included in the specific frequency component (C1). Alternatively, various kinds of frequency analysis processing such as wavelet analysis may be used to extract a periodic component included in the specific frequency component (C1). The same applies to the calculation (extraction) of the specific frequency component (C1).

In the above description, an instantaneous value of the specific frequency component (C1), a square root of the sum of squares of the specific frequency component (C1), a rate of change in the specific frequency component (C1), the ratio of the short-term moving average to the long-term moving average of the specific frequency component (C1), addition, subtraction, multiplication, and division of a plurality of specific frequency components (C1), exponentiation of the specific frequency component (C1), a combination of at least two thereof, or the like may be used as an index value, and the estimation process may be performed based on such an index value. The estimation process may be performed based on a duration in which such an index value exceeds a threshold value, the number of times such an index value exceeds a threshold value, or the like. The estimation process may be performed based on a combination of the specific frequency component (C1) and another characteristic frequency component (e.g., a frequency component corresponding to an integer multiple of the mechanical angular frequency of the motor (50)).

In the above description, the specific frequency component (C1) may be a frequency component corresponding to a single frequency component or frequency components corresponding to a frequency range based on a single frequency component.

In the above description, when the physical quantity is an AC signal, the estimation process may be performed based on either one of the two specific frequency components (C1) symmetrical with respect to the electrical angular frequency of the motor (50), or the estimation process may be performed based on both of the two specific frequency components (C1).

In the above description, the physical quantity may be a measured value, a command value, or an estimated value.

In the above description, the control unit (31) may be configured to perform the determination process using an algorithm constructed by a neural network or machine learning (an algorithm for determining a state based on a change in signal).

In the above description, the control unit (31) may be implemented by one processor or may be implemented by a plurality of processors. The control unit (31) may be implemented by a plurality of arithmetic processing devices (computers) that communicate with each other via a communication network.

While the embodiments and the modifications have been described, it will be understood that various changes in form and detail may be made without departing from the spirit and scope of the appended claims. In addition, the elements according to the above embodiments and modifications and other embodiments may be appropriately combined or replaced.

Industrial Applicability

As described above, the present disclosure is useful as a state estimation technique.

Reference Signs List

| | |
|---|---|
| 10 | drive system |
| 20 | motor drive device |
| 21 | converter |
| 22 | DC unit |
| 23 | inverter |
| 30 | control device (state estimation device) |
| 31 | control unit |
| 41 | phase current detection unit |
| 42 | electrical angular frequency detection unit |
| 50 | motor |
| 60 | power source |
| 70 | device |
| CC | compressor |
| RR | refrigeration system |
| RR1 | refrigerant circuit |
| FF | fan system |
| FF1 | fan |

**Claims**

1. A state estimation device for estimating a state of a device (70) in which a motor (50) driven by an inverter (23) is mounted, the state estimation device comprising:

   a control unit (31),
   the control unit (31) being configured to perform

      an estimation process for estimating the state of the device (70), based on a magnitude of a specific frequency component (C1) of a physical quantity obtained from the device (70), and
      a restriction process for restricting the estimation process or an operation of the motor (50) when a noise frequency component (Cn) included in the physical quantity and the specific frequency component (C1) satisfy a predetermined relationship, wherein

   the restriction process is a first restriction process for restricting the estimation process so that a predetermined estimation result is output, or a second restriction process for restricting the operation of the motor (50) so that no erroneous estimation is performed in the estimation process, and
   when a carrier frequency of the inverter (23) is represented by $f_c$, a sampling frequency that is a reciprocal of a cycle for sampling the physical quantity is represented by $f_s$, and an electrical angular frequency of the motor (50) is represented by $f_0$, a frequency of the noise frequency component (Cn) is

      a frequency given by any one of Expression 1, Expression 2, and Expression 3 below when the physical quantity is a DC signal, and
      a frequency given by any one of Expression 4, Expression 5, and Expression 6 below when the physical quantity is an AC signal, under a condition in which a greatest common divisor, which is at least 2, of two or more frequencies including the electrical angular frequency among the electrical angular frequency, the carrier frequency, and a frequency for sampling a modulation wave used for controlling the inverter (23) does not exist:

[Math. 1]

$$|f_c \pm 6Nf_0| \quad \cdots (1)$$
$$|Mf_s - 6Nf_0| \quad \cdots (2)$$
$$|Mf_s - |f_c \pm 6Nf_0|| \quad \cdots (3)$$
$$|f_0 \pm |f_c \pm 6Nf_0|| \quad \cdots (4)$$
$$|f_0 \pm |Mf_s - 6Nf_0|| \quad \cdots (5)$$
$$|f_0 \pm |Mf_s - |f_c \pm 6Nf_0||| \quad \cdots (6)$$

where M and N are natural numbers.

2. The state estimation device according to claim 1, wherein
the predetermined relationship is a relationship in which a frequency difference between the noise frequency component (Cn) and the specific frequency component (C1) is less than or equal to a predetermined frequency difference threshold value.

3. The state estimation device according to claim 2, wherein
the frequency difference threshold value is 3 Hz.

4. The state estimation device according to any one of claims 1 to 3, wherein
the first restriction process is a process for prohibiting execution of the estimation process.

5. The state estimation device according to any one of claims 1 to 3, wherein

the control unit (31) is configured to estimate the state of the device (70) in the estimation process, based on a result of comparison between a variable calculated based on an amplitude of the specific frequency component (C1) and a predetermined threshold value, and
the first restriction process is a process for correcting at least one of the threshold value and the amplitude of the specific frequency component (C1).

6. The state estimation device according to any one of claims 1 to 3, wherein
the second restriction process is a process for changing an operation condition of the motor (50) so that no erroneous estimation is performed in the estimation process.

7. The state estimation device according to claim 6, wherein
the process for changing the operation condition of the motor (50) is a process for changing at least one of the carrier frequency, the sampling frequency, and a mechanical angular frequency of the motor (50).

8. The state estimation device according to any one of claims 1 to 3, wherein
the second restriction process is a process for prohibiting the operation of the motor (50) under an operation condition in which the noise frequency component (Cn) and the specific frequency component (C1) satisfy the predetermined relationship.

9. The state estimation device according to any one of claims 1 to 8, wherein

a frequency of the specific frequency component (C1) is
a frequency that is at least one of 1 time, 1/3 times, and 2/3 times a mechanical angular frequency of the motor (50) when the physical quantity is a DC signal, and
at least one of a frequency obtained by adding a predetermined frequency to the electrical angular frequency, a frequency obtained by subtracting the predetermined frequency from the electrical angular frequency, and a frequency that is 3 times the electrical angular frequency when the physical quantity is an AC signal, the predetermined frequency being any one of 1 time, 1/3 times, and 2/3 times the mechanical angular frequency.

10. The state estimation device according to any one of claims 1 to 9, wherein
in the restriction process, when a predetermined restriction release condition is satisfied after restriction of the estimation process or restriction of the operation of the motor is started, the control unit (31) is configured to release the restriction after a predetermined standby release condition is satisfied.

11. The state estimation device according to any one of claims 1 to 10, wherein

the control unit (31) is configured to estimate presence or absence of an abnormality of the device (70) in the estimation process, and
the predetermined estimation result is an estimation result that is not an estimation result indicating that the device (70) is abnormal.

12. A state estimation device for estimating a state of a device in which a motor (50) is mounted, the state estimation device comprising:

a control unit (31),
the control unit (31) being configured to perform

an estimation process for estimating the state of the device (70), based on a magnitude of a specific frequency component (C1) of a physical quantity obtained from the device (70), and
a restriction process for restricting the estimation process or an operation of the motor (50), based on a magnitude of a periodic component included in a variable calculated based on the magnitude of the specific frequency component (C1), wherein

the restriction process is a first restriction process for restricting the estimation process so that a predetermined estimation result is output, or a second restriction process for restricting the operation of the motor (50) so that no erroneous estimation is performed in the estimation process.

13. A drive system comprising:

a motor drive device (20) configured to drive a motor (50) mounted in a device (70); and
a state estimation device configured to estimate an abnormality of the device (70), wherein
the state estimation device is the state estimation device according to any one of claims 1 to 12.

14. A refrigeration system comprising:

a refrigerant circuit (RR1) including a compressor (CC) including a motor (50); and
a state estimation device, wherein
the state estimation device is the state estimation device according to any one of claims 1 to 12, and is configured to estimate a state of the refrigeration system.

15. A fan system comprising:

a fan (FF1) including a motor (50); and
a state estimation device, wherein
the state estimation device is the state estimation device according to any one of claims 1 to 12, and is configured to estimate a state of the fan system.

16. A state estimation method for estimating a state of a device (70) in which a motor (50) driven by an inverter (23) is mounted, the state estimation method comprising:

an estimation step of estimating the state of the device (70), based on a magnitude of a specific frequency component (C1) of a physical quantity obtained from the device (70); and
a restriction step of restricting the estimation step or an operation of the motor (50) when a noise frequency component (Cn) included in the physical quantity and the specific frequency component (C1) satisfy a predetermined relationship, wherein
the restriction step is a first restriction step of restricting the estimation step so that a predetermined estimation result is output, or a second restriction step of restricting the operation of the motor (50) so that no erroneous estimation is performed in the estimation step, and
when a carrier frequency of the inverter (23) is represented by $f_c$, a sampling frequency that is a reciprocal of a

**EP 4 693 888 A1**

cycle for sampling the physical quantity is represented by $f_s$, and an electrical angular frequency of the motor (50) is represented by $f_a$, a frequency of the noise frequency component (Cn) is

a frequency given by any one of Expression 1, Expression 2, and Expression 3 below when the physical quantity is a DC signal, and
a frequency given by any one of Expression 4, Expression 5, and Expression 6 below when the physical quantity is an AC signal, under a condition in which a greatest common divisor, which is at least 2, of two or more frequencies including the electrical angular frequency among the electrical angular frequency, the carrier frequency, and a frequency for sampling a modulation wave used for controlling the inverter (23) does not exist:

[Math. 2]

$$|f_c \pm 6Nf_0| \cdots (1)$$
$$|Mf_s - 6Nf_0| \cdots (2)$$
$$|Mf_s - |f_c \pm 6Nf_0|| \cdots (3)$$
$$|f_0 \pm |f_c \pm 6Nf_0|| \cdots (4)$$
$$|f_0 \pm |Mf_s - 6Nf_0|| \cdots (5)$$
$$|f_0 \pm |Mf_s - |f_c \pm 6Nf_0||| \cdots (6)$$

where M and N are natural numbers.

17. A state estimation method for estimating a state of a device in which a motor (50) is mounted, the state estimation method comprising:

an estimation step of estimating the state of the device (70), based on a magnitude of a specific frequency component (C1) of a physical quantity obtained from the device (70); and
a restriction step of restricting the estimation step or an operation of the motor (50), based on a magnitude of a periodic component included in a variable calculated based on the magnitude of the specific frequency component (C1), wherein
the restriction step is a first restriction step of restricting the estimation step so that a predetermined estimation result is output, or a second restriction step of restricting the operation of the motor (50) so that no erroneous estimation is performed in the estimation step.

18. A state estimation program for causing a computer to execute the state estimation method according to claim 16 or 17.

# FIG.1

EP 4 693 888 A1

# FIG.2

# FIG.3

# FIG.4

# FIG.5

AMPLITUDE

C1

TIME

# FIG.6

AMPLITUDE

C1

TIME

# FIG.7

EP 4 693 888 A1

EP 4 693 888 A1

# FIG.8

START

S101
NOISE FREQUENCY COMPONENT (Cn) AND SPECIFIC FREQUENCY COMPONENT (C1) SATISFYING PREDETERMINED RELATIONSHIP? — NO

YES

S102
RESTRICT ESTIMATION PROCESS OR OPERATION OF MOTOR

S103
RESTRICTION RELEASE CONDITION SATISFIED? — NO

YES

S104
RELEASE RESTRICTION

RETURN

CALCULATION PROCESS

$C1$

RESTRICTION PROCESS ⟹ ESTIMATION PROCESS

MOTOR OPERATION

ESTIMATION RESULT

46

# FIG.9

AMPLITUDE

$f_m=83.1[Hz]$
$f_0=332.4[Hz]$
$f_c=5900[Hz]$
$N=3$

249.3[Hz]
($=f_0-f_m$)

415.5[Hz]
($=f_0-f_m$)

C1

Cn

C1

Cn

FREQUENCY

249.2[Hz]
($=f_0-|f_c-6Nf_0|$)

332.4[Hz]
($=f_0$)

415.6[Hz]
($=f_0+|f_c-6Nf_0|$)

# FIG.10

AMPLITUDE

FR

FR

Cn

C1

C1

Cn

FREQUENCY

$f_0-|f_c-6Nf_0|$

$f_0-f_m$

$f_0$

$f_0-f_m$

$f_0+|f_c-6Nf_0|$

# FIG.11

START

ACQUIRE INSTANTANEOUS VALUE OF
SPECIFIC FREQUENCY COMPONENT — S11

INSTANTANEOUS VALUE GREATER THAN
OR EQUAL TO UPPER LIMIT VALUE? — S12

NO

↓YES

ESTIMATE
ABNORMAL STATE — S13

ESTIMATE
NORMAL STATE — S14

END

# FIG.12

START

ACQUIRE RATE OF CHANGE
IN SPECIFIC FREQUENCY COMPONENT — S21

RATE OF CHANGE GREATER THAN OR
EQUAL TO UPPER LIMIT VALUE? — S22

NO

↓YES

ESTIMATE
ABNORMAL STATE — S23

ESTIMATE
NORMAL STATE — S24

END

# FIG.13

# FIG.14

START

S31

ACQUIRE CUMULATIVE TIME OF TIME
DURING WHICH SPECIFIC FREQUENCY
COMPONENT IS GREATER THAN OR
EQUAL TO UPPER LIMIT VALUE

S32

CUMULATIVE TIME GREATER
THAN OR EQUAL TO
THRESHOLD VALUE? — NO

YES

S33

ESTIMATE
ABNORMAL STATE

S34

ESTIMATE
NORMAL STATE

END

# FIG.15

SPECIFIC FREQUENCY
COMPONENT
(AMPLITUDE)

UPPER
LIMIT
VALUE

TIME

COUNT VALUE

THRESHOLD
VALUE

TIME

$t_1$  $t_2$  $t_3$  $t_4$  $t_5$  $t_6$  $t_7$  $t_8$  $t_9$  $t_{10}$  $t_{11}$  $t_{12}$

# FIG.16

```
           START

            │
            ▼
┌──────────────────────────────┐  S41
│   ACQUIRE PROPORTION          │
│   (TIME PROPORTION) OF        │
│ UPPER LIMIT VALUE EXCEEDING   │
│ TIME WITHIN DETERMINATION     │
│          TIME                 │
└──────────────────────────────┘
            │
            ▼                       S42
     ┌─────────────────────┐   NO
    ╱ TIME PROPORTION      ╲ ────────────┐
    ╲ EXCEEDING            ╱             │
     ╲ THRESHOLD VALUE?   ╱              │
      └──────────────────┘               │
            │ YES      S43               │    S44
            ▼                            ▼
┌────────────────────┐        ┌────────────────────┐
│     ESTIMATE       │        │     ESTIMATE       │
│  ABNORMAL STATE    │        │   NORMAL STATE     │
└────────────────────┘        └────────────────────┘
            │                            │
            ▼◄───────────────────────────┘

            END
```

# FIG.17

# FIG.18

START

S101

NOISE FREQUENCY COMPONENT (Cn) AND SPECIFIC FREQUENCY COMPONENT (C1) SATISFYING PREDETERMINED RELATIONSHIP? — NO

YES

S102

RESTRICT ESTIMATION PROCESS OR OPERATION OF MOTOR

S103

RESTRICTION RELEASE CONDITION SATISFIED? — NO

YES

S110

STANDBY RELEASE CONDITION SATISFIED? — NO

YES

S104

RELEASE RESTRICTION

RETURN

# FIG.19

```
                    ┌──────────┐
                    │  START   │
                    └────┬─────┘
                         │
   S201                  ▼
        ┌────────────────────────────┐  NO
        │      NOISE                  ├──────┐
        │   INTERFERENCE?             │      │
        └────────────┬───────────────┘      │
                     │ YES                   │
   S202              ▼                       │
        ┌────────────────────────────┐      │
        │ RESTRICT ESTIMATION PROCESS OR│   │
        │   OPERATION OF MOTOR        │      │
        └────────────┬───────────────┘      │
                     │                       │
   S203              ▼                       │
        ┌────────────────────────────┐  NO  │
        │  RESTRICTION RELEASE        ├──────┘
        │  CONDITION SATISFIED?       │
        └────────────┬───────────────┘
                     │ YES
   S204              ▼
        ┌────────────────────────────┐
        │     RELEASE                 │
        │   RESTRICTION               │
        └────────────┬───────────────┘
                     │
                     ▼
                ┌──────────┐
                │  RETURN  │
                └──────────┘
```

| DETERMINATION PROCESS | → | RESTRICTION PROCESS | ⇒ | ESTIMATION PROCESS |

CALCULATION PROCESS

C1

↓

MOTOR OPERATION

ESTIMATION RESULT

## FIG.20

## FIG.21

# FIG.22

# FIG.23

NUMBER OF
DATA VALUES

KURTOSIS: HIGH
(NOISE INTERFERENCE:
ABSENT)

DATA VALUE

NUMBER OF
DATA VALUES

KURTOSIS: LOW
(NOISE INTERFERENCE:
PRESENT)

DATA VALUE

# FIG.24

AMPLITUDE

PREDETERMINED TIME

AVERAGE
VALUE

C1

TIME

# FIG.25

AMPLITUDE

PERIODIC COMPONENT

THRESHOLD
VALUE

FREQUENCY

PREDETERMINED
BANDWIDTH

# FIG.26

# FIG.27

# FIG.28

FF

FFa

FF1

50

20

30

31

## INTERNATIONAL SEARCH REPORT

| International application No. |
| --- |
| **PCT/JP2024/013270** |

### A. CLASSIFICATION OF SUBJECT MATTER

*H02P 29/024*(2016.01)i
FI:  H02P29/024

According to International Patent Classification (IPC) or to both national classification and IPC

### B. FIELDS SEARCHED

Minimum documentation searched (classification system followed by classification symbols)

H02P29/024

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
| --- | --- | --- |
| A | JP 2022-39968 A (TAIDA ELECTRONIC IND CO., LTD.) 10 March 2022 (2022-03-10) paragraphs [0001]-[0060], fig. 1-7 | 1-18 |
| A | WO 2022/003758 A1 (MITSUBISHI ELECTRIC CORPORATION) 06 January 2022 (2022-01-06) paragraphs [0001]-[0091], fig. 1-15 | 1-18 |
| A | WO 2019/082277 A1 (MITSUBISHI ELECTRIC CORPORATION) 02 May 2019 (2019-05-02) paragraphs [0001]-[0059], fig. 1-15 | 1-18 |
| A | JP 2014-23370 A (SHIBAURA INSTITUTE OF TECHNOLOGY) 03 February 2014 (2014-02-03) paragraphs [0001]-[0040], fig. 1-4 | 1-18 |
| P, A | JP 2023-135655 A (DAIKIN INDUSTRIES, LTD.) 28 September 2023 (2023-09-28) paragraphs [0001]-[0147], fig. 1-14 | 1-18 |

☐ Further documents are listed in the continuation of Box C.    ☑ See patent family annex.

| | |
| --- | --- |
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | "&" document member of the same patent family |
| "P" document published prior to the international filing date but later than the priority date claimed | |

| Date of the actual completion of the international search | Date of mailing of the international search report |
| --- | --- |
| **07 May 2024** | **28 May 2024** |

| Name and mailing address of the ISA/JP | Authorized officer |
| --- | --- |
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (July 2022)

**INTERNATIONAL SEARCH REPORT**
Information on patent family members

| International application No. |
| :--- |
| **PCT/JP2024/013270** |

| Patent document cited in search report | | | Publication date (day/month/year) | Patent family member(s) | | | Publication date (day/month/year) |
| :--- | :--- | :--- | :--- | :--- | :--- | :--- | :--- |
| JP | 2022-39968 | A | 10 March 2022 | US | 2022/0069752 | A1 | |
| | | | | paragraphs [0001]-[0055], fig. 1-7 | | | |
| | | | | EP | 3961912 | A1 | |
| | | | | CN | 114114068 | A | |
| WO | 2022/003758 | A1 | 06 January 2022 | JP | 6824494 | B1 | |
| | | | | KR | 10-2023-0010708 | A | |
| | | | | CN | 115885469 | A | |
| WO | 2019/082277 | A1 | 02 May 2019 | US | 2020/0217895 | A1 | |
| | | | | paragraphs [0001]-[0073], fig. 1-15 | | | |
| | | | | KR | 10-2020-0053579 | A | |
| | | | | CN | 111247442 | A | |
| JP | 2014-23370 | A | 03 February 2014 | (Family: none) | | | |
| JP | 2023-135655 | A | 28 September 2023 | WO | 2023/176873 | A1 | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 6824494 B